# EUROPEAN PATENT APPLICATION

(11) **EP 0 884 689 A1**
(43) Date of publication of application: **16.12.1998**
(21) Application number: 97304014.0
(22) Date of filing: 10.06.1997
(51) Int. Cl.: G06F 17/50

(54) **Apparatus for defining properties in finite-state machines**

(71) Applicant: LUCENT TECHNOLOGIES INC., Murray Hill, New Jersey 07974-0636 (US)
(72) Inventor: De Palma, Gary F., Branchburg, New Jersey 08876 (US); Kurshan, Robert Paul, New York, New York 10014 (US); Glaser, Arthur Barry, Watchung, New Jersey 07060 (US); Wesley, Glenn R., Allentown, Pennsylvania 18104 (US)
(74) Representative: Watts, Christopher Malcolm Kelway, Dr.

(57) **Abstract**

A method and apparatus for defining a system design specification by using a finite set of templates that have a format for accepting a set of system expression such that a selected template, when filled with the system expressions, defines an expected behavioral attribute of the system. In one illustrative embodiment, each template has a set of qualifiers and a set of entry blanks, wherein each qualifier is associated with an entry blank. In such an embodiment, the set of entry spaces may comprise a fulfilling condition entry space for accepting a system expression that defines a required or assumed event of the system model, an enabling condition entry space for accepting a system expression that defines a precondition for starting a check of the required or assumed event, and a discharging condition entry space for accepting a system expression that defines a condition after which said fulfilling condition is no longer required or assumed by the system model. Filling the entry spaces of a selected template with the appropriate system expression can form an expression that defines an expected behavior of the system model. Thus, a set of filled templates can define a set of expected behaviors of the system model (i.e. a system design specification). The system design specification can then be used to generate computer-executable code (e.g. automata) for testing the expected behavioral attributes of the system. For example, each filled template of the system design specification can be converted to an automaton by a given subroutine.

## Description

### Field of the Invention

The present invention relates to computer-aided verification or simulation, and more particularly, to the specification of properties used in verification or simulation systems.

### Background of the Invention

A long-standing problem in the design of large-scale, highly complex systems is verifying that the system will behave in the manner intended by its designers. One approach to this problem is to simply try out the system, either by building and testing the system itself or by building and testing a model of the system. Since most new systems require several revisions or redesigns before they behave as intended by the system designer, many system designers choose to first build and test a model of the system. This enables the designer to check the system design by testing the behavior of the system model so that any causes for system redesign can be identified before incurring the expenses associated with building the system itself.

In one method of building and testing a system model, called computer simulation, a programmer "builds" the system model by writing a computer program that simulates the intended properties (i.e. functions and features) of the system. The computer program, or system model, is designed to accept inputs, perform functions and generate outputs in the same manner as would the actual system. In computer simulation, the system model is tested by running a checking program which checks how the system model behaves in response to various inputs. Basically, the checking program controls the inputs to the system model, and checks whether the behavior of the model to a given set of inputs is the behavior expected or intended by the system designer. For example, in checking a model of a telephone, a checking program would be operable to control the various telephone model inputs (e.g. AC power level, control signals, and dialed numbers), and monitor the behavior of the telephone model in response to such inputs.

A significant problem with computer simulation, however, is that only the behaviors anticipated by the designer can be checked. That is, the designer can only check those behaviors which the checking program is designed to check. This is a problem because a programmer may not posses the system knowledge that is necessary to anticipate or incorporate all of the expected system behaviors into the checking program. Notwithstanding this, even a designer knowledgeable about the system design may find it hard to anticipate some behavioral attributes of a sufficiently complex system. As a result, computer simulation is not always a reliable method of testing the properties (i.e. intended actions and features) of a system design.

As the limitations of simulation have become apparent, interest has grown in another method of building and testing a system model, called formal verification. In formal verification, to test a model of a system, a programmer is required to "build" both a system model, which maybe the same model used for simulation, and a system design specification. The programmer may "build" the system model by writing a computer program or a set of logical expressions that define an implementation of the system, and may "build" the system design specification by writing a set of logical expressions that define the intended or expected behavioral attributes of the system. Basically, the system model is designed to accept inputs, perform functions and generate outputs in the same manner as would the actual system, if built, and the system design specification is designed such that each logical expression defines an intended or expected behavioral attribute of the system or system model.

With a system model and a system design specification, a verification tool can be used to test whether the behavior of the system model is consistent with the intended or expected behaviors defined by the design specification. Often, this is done by converting both the system model and the system design specification into a state machine. The system model state machine can be described as a system or set of states and transitions that reflects or mimics how the system model would behave in response to any given set of inputs. The system design specification state machine can be described as a system or a set of states and transitions that defines how the designer intends or expects the system model to act in response to a given set of inputs. For example, the design specification state machine might define which states the system model state machine may enter (i.e. "good" states) and may not enter (i.e. "bad" states) during operation, when given a certain set of inputs. Thus, to test whether the system model behaves according to the expected behaviors defined in the design specification, the verification tool would control and/or vary the inputs to the system model state machine and check whether the system model state machine can possibly enter any states defined by the design specification state machine as "bad" states. If so, the system design is said to fail the system design specification, and a system redesign may be in order.

Thus, it is clear that the accuracy and reliability of a formal verification system directly depends on the accuracy of the programmer in writing the logical expressions that define the system design specification. If the logical expressions do not accurately define the intended or expected behaviors of the system, the design specification state machine will not accurately define which states the system model state machine may and may not enter, given a set of inputs. Moreover, if the design specification state machine fails to accurately define the bad states, then any formal verification test will fail to check the system model for the appropriate or intended behavior. Thus, the reliability of formal verification ultimately depends on the accuracy of the programmer in writing the logical expressions that define the system design specification.

Heretofore, when writing the logical expressions that define a system design specification, programmers are literally faced with the task of working from a blank page. That is, the designers must decide how to express each expected behavioral attribute beginning with a blank page and a set of logical operators. To illustrate, most present day programmers use temporal logic to write the required logical expressions. The temporal logic expressions can be generated by using a set of temporal logic operators which may include "G" meaning "at every state", "F" meaning "eventually", "A" meaning "along all state transition executions, "∼" meaning "not", "∨" meaning "or", and "→" meaning "implies." Thus, to generate a logical expression that defines a given expected behavioral attribute of the system, the programmer must understand the logical meaning of each operator, decide which operators to use, and decide how to associate the chosen operators with the appropriate system variables or system parameters to ultimately form an expression of the behavior being defined.

For example, temporal logic can be used to express a behavioral attribute such as turning on an oven when a temperature goes below a certain value. One temporal logic programmer may express this behavior as AG(t → AF(∼p ∨ w)), where the parameter "t" means the temperature goes below the stand value, "p" means the oven is powered, and "w" means the oven is turned on. Another programmer, however, may decide that this behavior could be expressed in temporal logic as G(t→F(w)), wherein the parameters "t" and "w" are the same as described above. Although each expression may appear to its respective programmer as accurately defining the system behavior, the expressions do not have the same logical meaning and thus do not define the same system behavior. As a result, it is very possible that different programmers can write completely different logical expressions for defining the same system property, with one logical expression not actually defining the same intended behavior as the other. Thus, unless the programmer posses both a detailed knowledge of the system design and a high level of skill in the logic being used to define the design specification, use of conventional formal verification tools to test a system design can be quite difficult and unreliable.

### Summary of the Invention

A first apparatus according to the invention is set out in claim 1.

Each said entry space may be a parameterized entry space such that each said template is a parameterized template. Each said parameterized template may have a structure similar to every other parameterized template in said finite set of templates. Said finite set of parameterized templates may comprise a set of property templates and a set of constraint templates.

In apparatus as set out in claim 3 said selected template may have a format comprising AYBXCZ. Said enabling qualifier (A) may be a qualifier selected from the group comprising AFTER, and IF REPEATEDLY. Said fulfilling qualifier (B) may be a qualifier selected from the group comprising ALWAYS, NEVER, EVENTUALLY, and EVENTUALLY ALWAYS. Said discharging qualifier (C) may be a qualifier selected from the group comprising UNLESS, UNTIL, UNLESS AFTER, and UNTIL AFTER.

A subset of said set of entry spaces may have at least one associated qualifier. Said associated qualifiers may be selected from a fixed set of qualifiers. Said fixed set of qualifiers may comprise AFTER, IF REPEATEDLY, ALWAYS, NEVER, EVENTUALLY, EVENTUALLY ALWAYS, UNLESS, UNTIL, UNLESS AFTER, UNTIL AFTER, and CLOCK.

The means for filling a set of entry spaces may comprise a processor for presenting a set of query screens to a programmer through an interface. Said set of query screens may be operable to receive said system expressions from said programmer. Said finite set of templates may be stored in a memory.

The apparatus may further comprise means for selecting said selected template from said finite set of templates.

A second apparatus according to the invention is set out in claim 5. Said finite set of templates may include a set of property templates and a set of constraint templates.

Each said template may have a set of qualifiers comprising a fulfilling qualifier (B), an enabling qualifier (A) and a discharging qualifier (C).

Said parameter associated with said fulfilling qualifier (B) may represent a fulfilling condition (X) which defines an event required by a system behavioral attribute, said parameter associated with said enabling qualifier (A) may represent an enabling condition (Y) which defines a precondition for starting a check of said fulfilling condition (X), and said parameter associated with said discharging qualifier (C) may represent a discharging condition (Z) which signifies a condition after which said fulfilling condition (X) is no longer required. Each said selected template may have a format comprising a form of AYBXCZ, wherein AY and CZ are optional. Said means for receiving a set of inputs may be operable to present a set of queries to a programmer to request said parameters representing said fulfilling condition (X), said enabling condition (Y) and said discharging condition (Z). Said set of queries may be stored in a memory. Said selected template may be a system property template, in which case: said enabling qualifier of said selected template may be a qualifier selected from the group comprising AFTER, and IF REPEATEDLY; said fulfilling qualifier of said selected template may be a qualifier selected from the group comprising ALWAYS, NEVER, EVENTUALLY, and EVENTUALLY ALWAYS; and said discharging qualifier of said selected template may be a qualifier selected from the group comprising UNLESS, UNTIL, UNLESS AFTER, and UNTIL AFTER. Said selected template may be a system constraint template, in which case: said enabling qualifier of said selected template may be a qualifier selected from the group comprising AFTER, and IF REPEATEDLY; said fulfilling qualifier of said selected template may be a qualifier selected from the group comprising ASSUME ALWAYS, ASSUME NEVER, ASSUME EVENTUALLY, ASSUME EVENTUALLY ALWAYS, ALWAYS, NEVER, EVENTUALLY, and EVENTUALLY ALWAYS; and said discharging qualifier of a selected template may be a qualifier selected from the group comprising UNLESS, UNTIL, UNLESS AFTER, and UNTIL AFTER.

A system according to the invention is set out in claim 6. Said testing tool may be a verification tool. Said testing tool may be a simulation tool. Said body of computer executable code may define automata for use in testing said system model behavior in a formal verification tool.

A third apparatus according to the invention is set out in claim 7. Said finite set of templates may comprise a set of property templates and a set of constraint templates. Said property templates may have the same format as said constraint templates. Each said parameter may be expressed in terms of system variables and system inputs. Said format for each said template may comprise a fixed set of entry spaces. Said fixed set of entry spaces may comprise a fulfilling condition entry space (X) for accepting a parameterized input that defines a required event of the system model, an enabling condition entry space (Y) for accepting a parameterized input that defines a precondition for starting a check of said required event, and a discharging condition entry space (Z) for accepting a parameterized input that signifies a condition after which said required event is no longer required. Each said entry space may be qualified by a qualifier. Said fulfilling condition entry space (X) may be qualified by a first qualifier (A), said enabling condition entry space (Y) by a second qualifier (B), and said discharging conditon entry space (Z) by a third qualifier (C).

Said format for each said template may comprise a form of BXAYCZ. Said parameterized inputs accepted into said fulfilling condition entry space, said enabling condition entry space, and said discharging condition entry space may be obtained through a set of query screens.

Said finite set of templates may be stored in a memory. Said qualifiers may be chosen from a set of qualifiers comprising AFTER, IF REPEATEDLY, EVENTUALLY, ASSUME EVENTUALLY, EVENTUALLY ALWAYS, ASSUME EVENTUALLY ALWAYS, UNLESS, UNTIL, UNLESS AFTER, UNTIL AFTER, NEVER, and ALWAYS.

Methods according to the invention are set out in claims 8 and 9.

According to the present invention, a designer can accurately define a system design specification through a finite set of templates. The finite set of templates provide a relatively small number of easy to understand expressions that greatly simplify, clarify and make more reliable the undertaking of defining a design specification. In general, each template has a set of entry spaces for accepting a set of system expressions. Each system expression, which is written in terms of system model variables, defines a condition or "actual value" of the system model. When such a set of system expressions are accepted into the parameterized entry spaces of a template, the "filled" template forms a logic expression that defines an expected behavioral attribute of the system. Thus, a design specification can be easily defined by selecting an appropriate template for each expected behavior of the system, and inputting the relevant system expressions in the entry spaces of the selected templates.

In one illustrative embodiment, each entry space of each template has an associated qualifier that acts as a logic operator. Thus, to define an intended behavioral attribute of the system the programmer must first select a template, from the finite set of templates, that has a set of qualifiers and associated parameterized entry spaces that the programmer believes can be used to form a logical expression that best defines the intended behavioral attribute. Once the appropriate template is selected, the programmer can enter the system expressions into the entry spaces to "fill" the template. The resultant "filled" template forms a logical expression that defines the intended behavioral attribute.

An example of a template having a fixed set of qualifiers and entry spaces is "AFTER( )EVENTUALLY( )." This template has the set of qualifiers "AFTER" and "EVENTUALLY," and the set of entry spaces represented by the brackets "( )." This template can be used to define an intended system behavior such as turning on an oven when the temperature falls below 30 degrees Celsius. To do this, the programmer would simply enter the relevant system expressions, in terms of the system model variables, into the parameterized entry spaces. For example, in a system model wherein the expression "t" means "the temperature is less than 30 degrees Celsius" and wherein the expression "w" means "the oven is on," the programmer would simply enter the expression "t" in the entry space associated with the qualifier "AFTER," and enter the expression "w" into the entry spaces associated with the qualifier "EVENTUALLY." The resultant "filled" template, "AFTER(t)EVENTUALLY(w)," forms a logical expression which defines the behavior: "after the temperature is less than 30 degrees Celsius, then eventually the oven is on." As can be seen, the qualifiers "AFTER" and "EVENTUALLY" take on their intuitive meaning in the English language, thus making the meaning of each template easier to understand than the above described temporal logic expressions.

In an illustrative embodiment, a programmer can select the appropriate templates and enter the relevant parameters through query screens. The query screens can be presented to the programmer through a graphical interface in the form of a set of screens that provide the programmer with the means to peruse the finite set of templates and select the appropriate template for defining a given behavioral attribute, and the means to "fill" the selected template with the relevant parameters.

Advantageously, the present invention eliminates the need for a highly skilled programmer to write numerous and/or complex logic expressions required to define system design specification for use in prior art verification and simulation tools. Thus, the present invention overcomes, to some extent, the limitations of the prior art. These and other features of the invention will become more apparent in view of the detailed description of illustrative embodiments when taken with the drawings. The scope of the invention, however, is limited only by the claims attached hereto.

### Brief Description of the Drawings

FIG 1 is block diagram of an illustrative embodiment of an apparatus for defining a design specification of a system, according to the present invention;
FIG. 2 is a pictorial view of an illustrative embodiment of a template presented through the graphical interface shown in FIG. 1.
FIG. 3 is a block diagram of an illustrative embodiment of a method for defining a design specification of a system, according to the present invention; and
FIG. 4 is a block diagram view of an illustrative embodiment of a system for verifying the behavior of a model, according to the present invention.

### Detailed Description of Illustrative Embodiments of the Invention

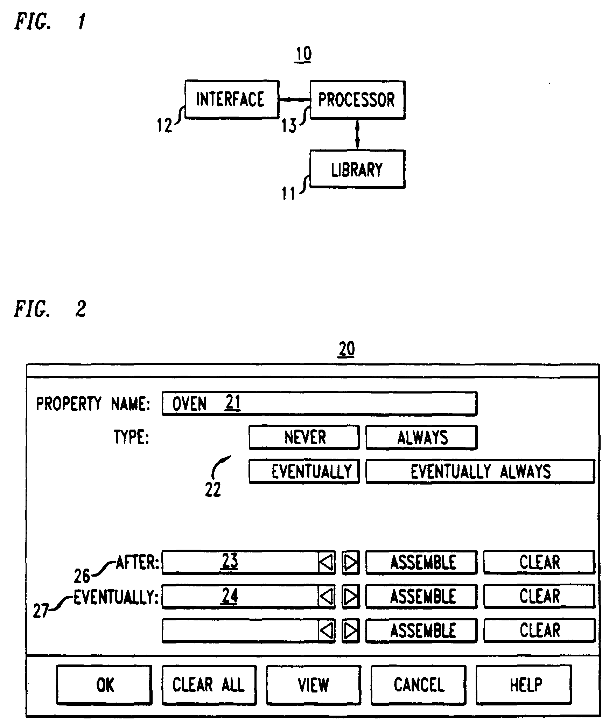

Referring now to FIG. 1 there is shown a block diagram of an illustrative embodiment of an apparatus for defining a design specification of a system, according to the present invention, hereinafter referred to as apparatus 10. As shown, apparatus 10 has a processor 13 electrically coupled to an interface 12 and a library 11. Interface 12 can be a standard graphical interface, including a monitor and a keyboard. Library 11, which can be an electronic storage medium such as a read only memory, contains a finite set of templates.

The finite set of templates provide a relatively small number of easy to understand expressions that greatly simplify, clarify and make more reliable the undertaking of defining a design specification. Each template has a set of entry spaces for accepting a set of system expressions related to the system for which an expected or intended behavioral attribute is being defined. When such a set of system expressions are accepted into a selected template, the "filled" template forms a logic expression that defines the expected behavioral attribute of the system. Thus, a design specification can be easily defined by selecting an appropriate template for each expected behavior of the system, and inputting the relevant system expressions in the template entry spaces.

Referring now to FIG. 2 there is shown a one illustrative embodiment of a query screen that provides a programmer with a means for selecting and "filling" templates to define system behavioral attributes, hereinafter referred to as query screen 20. As shown, query screen 20 provides an entry space 21 for naming the behavior being defined, and a selection bar 22 that provides the programmer with a means for selecting a type of behavior being defined. The name entered in entry space 21 can be any name the programmer wishes to use when defining an expected behavior of the system. The selected behavior type 22, however, depends on which set of qualifiers that the programmer determines are required to express the expected behavioral attribute. As shown, when the programmer determines that the system behavioral attribute being defined requires a template with "EVENTUALLY" as one of the qualifiers, then the programmer can select the "EVENTUALLY" behavior type.

Once the programmer enters the behavior name (e.g. OVEN) and selects the behavior type (e.g. EVENTUALLY), a window (not shown) that lists the finite set of templates is presented through screen 20 to the programmer. The programmer can then select, from the finite set of templates, the template having the appropriate format for defining the intended behavior. Once the appropriate template is selected, query screen 20 presents the template qualifiers 26 and 27 and their associated entry spaces 23 and 24, as shown. The programmer can then enter the appropriate system expressions, written in terms of system model variables (e.g. "t" and "w"), in the entry spaces to fill the template.

As shown, the system expression "t" which represents the mathematical expression "temp<30," where "temp" is a system model variable for temperature, is entered into entry space 23, whereas the system expression "w," which represents the mathematical expression "the oven is on," is entered into entry space 24. The filled template has the form "AFTER(t)EVENTUALLY(w). In using the above described symbol definitions, this expression means: "after the temperature falls below 30 degrees Celsius, the system should eventually turn on the oven." Thus, through query screen 20, the programmer can easily define such expected system behaviors.

Similarly, by repeating the process just described for a set of behavioral attributes of a system model, query screen 20 can be used to define a system model design specification. The system model design specification can be used to generate computer-executable code for testing the expected behavioral attributes of the system. For example, the set of filled templates can be converted to automata, i.e. a state transition system having certain sequential states which serve to distinguish between acceptable and unacceptable behaviors, by a set of subroutines. Thus aspect of the invention will be discussed in greater detail below.

The format of query screen 20 is just an illustrative example of one method for enabling a programmer to select and fill a template to define a behavioral attribute. In another embodiment of the present invention, a query screen having another format may be used. For example, the query screen may have a format that enables a programmer to search the entire finite set of templates, without having to enter a behavior type 22. And, the query screen may enable the programmer to select an option that initiates the retrieval of system expressions from an electronic storage medium to fill the entry spaces of the selected template.

Thus, considering the operation of apparatus 10 in greater detail, it will be appreciated that apparatus 10 can be used to define a design specification for a system having a set of expected behavioral attributes. To illustrate, processor 13 can present the finite set of templates from library 11 to a programmer or designer, through interface 12. The programmer can then select, for each system behavioral attribute, a template having a set of qualifiers and associated entry spaces that provides the means to best express the system behavioral attribute. Once a template is chosen for expressing a given system behavioral attribute, processor 13 can query the programmer to enter the appropriate system expressions into the entry spaces of the template. The resultant "filled" template is a logic expression, composed of a set of qualifiers and associated system expressions, that defines the given system behavioral attribute. As a result, the programmer can repeat the process for a set of system behavioral attributes to ultimately define a system design specification.

To illustrate, system 10 can be used to define an expected behavioral attribute of a system that, among other things, turns on an oven when a temperature falls below 30 degrees Celsius. To define this expected behavioral attribute, a programmer can peruse the finite set of templates and identify a template having a set of qualifiers and associated entry spaces (i.e. a template format) which the programmer believes can best express or define the expected behavioral attribute. To identify such a template, the programmer can first decide on the general template format (i.e. set of qualifiers and entry spaces) that can be used to express or define the behavior of turning on an oven under the stated conditions. That is, the programmer may simply write a concise English statement of the behavioral attribute and extract from that concise statement a general template format that can be used to define the behavior.

For example, in choosing a template to express or define the above described behavior, the programmer may first write the statement: "After the temperature goes below 30 degrees Celsius, eventually the oven is turned on." From this simple statement, the programmer can decide that the general form of a template for expressing this behavior is "AFTER (the temperature goes below 30 degrees Celsius) EVENTUALLY (the oven turns on)," wherein "AFTER" and "EVENTUALLY" qualify the associated conditions "the temperature goes below 30 degrees Celsius" and "the oven turns on," respectively. With this general template format, the programmer can peruse the finite set of templates and identify a template having a matching format. Once the appropriate template is selected, the programmer can enter or "fill" the template with the appropriate details (i.e. the system expressions) specific to the system behavioral attribute being defined.

Of course, in formulating the English language prototype, the programmer needs to bear in mind the set of available templates. For this reason, it is important that the finite set of templates be a small set. On the other hand, it would be useful for the programmer to know that the given set of templates suffice to express all properties that could be expressed with such templates. It would therefore be useful, but not essential, to have a finite set of templates that is "complete" in the sense that there exists no additional template that is not in the set which could express a property not already expressible with templates already in the set.

In the current example, the programmer may peruse library 11 and find a template having the format "AFTER(enabling condition)EVENTUALLY(fulfilling condition)." If such a template is found and selected, the programmer may use interface 12 to "fill" the entry spaces of the selected template with the appropriate system expressions stated above. The resultant "filled" template would then be "AFTER (t) EVENTUALLY (w), wherein "t" is a system expression (e.g. a Boolean expression) that means "the temperature is below 30 degrees Celsius," and "w" is a system expression (e.g. a Boolean expression) that means "the oven is turned on." In taking the intuitive meaning of the qualifier "AFTER" and "EVENTUALLY" of the selected template, the resultant "filled" template is easily understood to define the behavior "after the temperature falls below 30 degrees Celsius, then eventually the oven must turn on." From this example, it can be seen that the present invention can be used to define a set of system behavioral attributes, and thus define a system design specification. That is, each behavioral attribute of a system can be defined by selecting the appropriate template, from the finite set of templates, and inputting the appropriate system expressions (e.g. Boolean expressions) to form a set of "filled" templates that define a system design specification.

It should be noted that, in an illustrative embodiment of the invention, the behavioral attributes of a system can be expressed as properties and/or constraints, wherein a property is a function or feature of the system, and a constraint is an assumption about the operation of the system due to the system environment. That is, under some testing conditions, it may be required that both a property and a constraint be used to define an expected behavior. For example, in the above described system, the behavioral attribute of turning on an oven may be predicated on the requirement that the design retains power over a sufficiently long period of time.

When defining a design specification for such a system, the programmer may select a first template to define the function of turning on an oven under the given conditions, and a second template to define the condition that the oven is assumed to always be sufficiently powered. The combination of the first and second template can be used to test the system model function of turning on an oven, while eliminating the possibility that the behavior of the oven will be deemed to have failed only because the system model was not powered-up for a sufficiently long period of time. In such an embodiment, the first template can be called a property template because it is used to define a function or feature of the system (i.e. system property), whereas the second template can be called a constraint template because it is used to place a limit on the testing environment of the system (i.e. system constraint). The property template and constraint template can be chosen and "filled" as described above.

To illustrate, the programmer can first select and fill-in the template having the format "AFTER(enabling condition)EVENTUALLY(fulfilling condition)" with the appropriate system expressions to define the intended property of turning on an oven. The resultant property template would be AFTER(t)EVENTUALLY(w), as described above. Then, the programmer can select, from the finite set of templates, a second template for defining the above described system constraint. For example, the programmer can select a template having the format ASSUME ALWAYS(fulfilling condition) wherein the fulfilling condition is the condition that the system is sufficiently powered. Once the template having such a format is chosen, the programmer simply fills-in the entry space for the fulfilling condition a system expression, written in terms of system variables, that describe the fulfilling condition.

In one embodiment, wherein "p" is a system expression representing, if true, the condition that the system is sufficiently powered, the resulting constraint template would be ASSUMEAL WAYS(p). In such an embodiment, the combination of the filled property template, AFTER(t)EVENTUALLY(w), and the filled constraint template, ASSUME ALWAYS(p), defines the expected behavioral attribute of turning on the oven when the temperature falls below 30 degrees Celsius, assuming that the system model was powered-up for a sufficient amount of time. Thus, by combination of the property template and the constraint template, just described, into the design specification, the programmer eliminates the possibility that a test of the system model oven functionality will report a failure due to insufficient system power. Thus, it can be seen that by separating the library of templates into properties templates and constraint templates, the system design specification becomes much easier to express and understand.

From this example, it can be seen that in one illustrative embodiment of the invention can include a library having a finite set of property templates and a finite set of constraint templates. From such a library, a programmer can define both properties and constraints of a system to define a system design specification. In addition, such a library can include property templates and constraint templates that have the same general structure or format (i.e. set of qualifiers and associated entry spaces for system parameters or conditions) for defining system behavioral attributes. Using such similarly structured templates to define a system design specification, according to the present invention, will simplify the appearance of the templates to the programmer, and may simplify the generation of computer code from the filled templates to test the system behavioral attributes through verification or simulation tools.

Moreover, in yet another embodiment of the invention, the programmer may perform the function of selecting and filling the template through a means that does not utilize a query screen. Thus, it is understood herein that those skilled in the art can employ any desired means for selecting a template from the finite set of templates, and for filling the selected template with the appropriate system information.

In some embodiments, each template may have the same number of parameterized entry spaces, wherein each entry space is associated with a qualifier. To illustrate, each template may have three qualifiers: an enabling qualifier, a fulfilling qualifier and a discharging qualifier. Each such qualifier may be associated with a parameterized entry space of the template such that the qualifier qualifies the specific system expression (i.e. system condition) entered into the entry space. A system expression entered into the parameterized entry space associated with a fulfilling qualifier can be said to represent a fulfilling condition of the system, wherein the fulfilling condition defines an event required by a system behavioral attribute. A system expression entered into the parameterized entry space associated with an enabling qualifier can be said to represent an enabling condition of the system, wherein the enabling condition defines a precondition for starting a check of the fulfilling condition. A system expression entered into the parameterized entry space associated with a discharging qualifier can be said to represent a discharging condition of the system, wherein the discharging condition signifies a condition after which said fulfilling condition is no longer required. Thus, to fill the parameterized entry spaces of a selected template, the programmer need only be able to write the appropriate system expressions, wherein each system expression uses program variables of the system model to describe the appropriate condition or parameter. In one illustrative embodiment, some parameterized entry spaces may be left blank. Such an embodiment provides the programmer with the ability to define a larger set of system properties and system constraints. To illustrate, if the third parameterized entry space, i.e. the discharging condition, of the template "AFTER( )ASSUMEALWAYS( )UNLESS( )" is left blank, the resulting template defines a different template, namely "AFTER( ) ASSUMEALWAYS( ).

It should be noted that the templates are not limited to a three-qualifier format, as described above. Rather, a template library according to the present invention may include templates that have no qualifiers, only a set of entry spaces. Or the templates may have having at least one qualifier and at least one associated entry space. For example, a library may include a template having the format "EVENTUALLY (fulfilling condition)." Or, a library may include a template with one qualifier having and associated entry space, and two optional qualifiers with associated entry spaces. For example, a template may have the format "Enabling Qualifier(enabling condition) Fulfilling Qualifier(fulfilling condition) Discharging Qualifier(discharging condition)," wherein only the fulfilling condition requires entry of a system expression for the template to be "filled." A still further possibility is to provide a means for a programmer to choose any one of several qualifiers, from a list of possible qualifiers, to form a desired template format. Any such template may be used, as described above, to define a design specification.

It should also be noted that the templates of a library composed of both a set of property templates and a set of constraint templates, can have a subset of property templates which have an enabling qualifier, wherein the enabling qualifier of a selected property template may be AFTER, or IF REPEATEDLY. In addition, each property template may have a fulfilling qualifier, wherein the fulfilling qualifier of a selected property template may be ALWAYS, NEVER, EVENTUALLY, or EVENTUALLY ALWAYS. Yet further, each property template may have a discharging qualifier, wherein the discharging qualifier of a selected template may be UNLESS, UNTIL, UNLESS AFTER, or UNTIL AFTER. In each selected property template, the qualifiers can be given their intuitive English language meaning, as described above.

It should further be noted that such a library, just described, may include a set of constraint templates, wherein each constraint template has an enabling qualifier, wherein the enabling qualifier of a selected constraint template may be AFTER, or IF REPEATEDLY. In addition, each constraint template may have a fulfilling qualifier, wherein the fulfilling qualifier of a selected constraint template may be ASSUME ALWAYS, ASSUME NEVER, ASSUME EVENTUALLY, or ASSUME EVENTUALLY ALWAYS. Yet further, each constraint template may have a discharging qualifier, wherein the discharging qualifier of a selected constraint template may be UNLESS, UNTIL, UNLESS AFTER, or UNTIL AFTER. In each selected constraint template, the qualifiers can be given their intuitive English language meaning, as described above.

In yet another illustrative embodiment, templates may have sequential elements that refer to a sequential clock of the system model. For example, in the template "AFTER(enabling condition)ByCLOCK(N)(fulfilling condition)UNLESS(discharging condition)," the sequential element ByCLOCK(N) may be used to define a parameterized entry space that represent a fulfilling condition which is required to occur within N clock ticks of a specified enabling condition.

An illustrative embodiment of a finite set of templates is shown and defined in Appendix A, attached hereto. As shown, Appendix A lists a substantially complete finite set of templates. That is, the set of templates listed in Appendix A substantially suffices to enable a programmer to express all the expected behavioral attributes of a system that could be expressed through such templates. Or, stated differently, there is no template that can be added to the finite set of templates listed in Appendix A that could be used to express a system behavior not already expressible by the templates listed therein.

It should be noted that an apparatus embodying the present invention need not obtain the conditions or system expressions to fill the template from a manual entry by a programmer. Such entries can be made by any means desired. For example, an apparatus according to the present invention can receive an input from other systems or machines, and/or obtain the information from a computer disk having the system expressions stored thereon. In addition, an apparatus according to the present invention, can present to a programmer or a system, a set of query screens that provide the means for selecting the appropriate template and for entering the system expressions to fill the selected template, as described above.

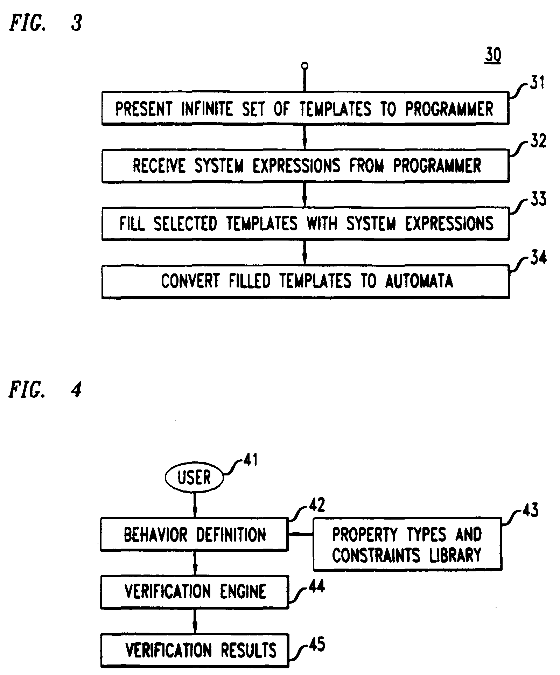

Referring now to FIG. 3, there is shown a pictorial view of one illustrative embodiment of a method for defining a design specification of a system, according to the present invention, herein after referred to as method 30. As shown, method 30 includes at 31, the step of presenting the finite set of templates through query screens to enable the programmer select templates, from a finite set of templates, that have the appropriate format for defining expected behavioral attributes of the system. Once a template is chosen for a given expected behavioral attribute, then at step 32 the required system expressions are received from the programmer. The received system expressions are then input, at step 33, to fill the selected template, and thus form an expression of the expected behavioral attribute. This process is repeated for expected behavioral attributes being defined to form a system design specification. The system design specification can then be translated at step 34 into automata which can be used by a verification tool to test whether the system model behaves as expected (i.e. as defined in the system design specification). Such a translation can be performed by a set of subroutines.

One illustrative embodiment of such a set of subroutines is shown in Appendix A. In Appendix A there is shown a set of templates, wherein each template has an associated subroutine for translating the template, when filled, into an automation, a set of automatons, i.e. automata, for a state transition system having certain sequential states which serve to distinguish between acceptable behavior and unacceptable behavior of the system model. As a result, by translating all the filled templates that comprise a system design specification, through the set of subroutines listed in Appendix A, the system design specification can be converted to automate that can be used by a verification tool to test whether the behavior of the system model is the intended behavior defined in the system design specification. The present invention, however, is not limited to the specific set of subroutines shown in Appendix A. A set of subroutine can be designed in any form desired by those skilled in the art to accomplish the method/apparatus/system of translating a set of filled templates, as described herein.

A functional block diagram of a system for defining a system model design specification, translating the system model design specification to automata and checking the behavior of the system model with the automata, according to the present invention, is shown in FIG. 4. As shown, a programmer 41 establishes a definition of the expected behaviors of the model at 42. A set of property templates and constraint template are chosen, at 43, from a library having a finite set of templates. The programmer can then fill the selected template with system expressions written in terms of system model variables, to define a system design specification. The system design specification can then be used to generate a set of logical expressions (i.e. automata) which are fed, along with a definition of the model, to a verification engine at 44 to check whether the model behaves as defined in the design specification. The results of the verification are reported at 45.

While the invention has been particularly shown and described with reference to various embodiments, it will be recognized by those skilled in the art that modifications and changes may be made to the present invention without departing from the scope thereof. Therefore, the invention in its broader aspects is not limited to specific details shown and described herein.

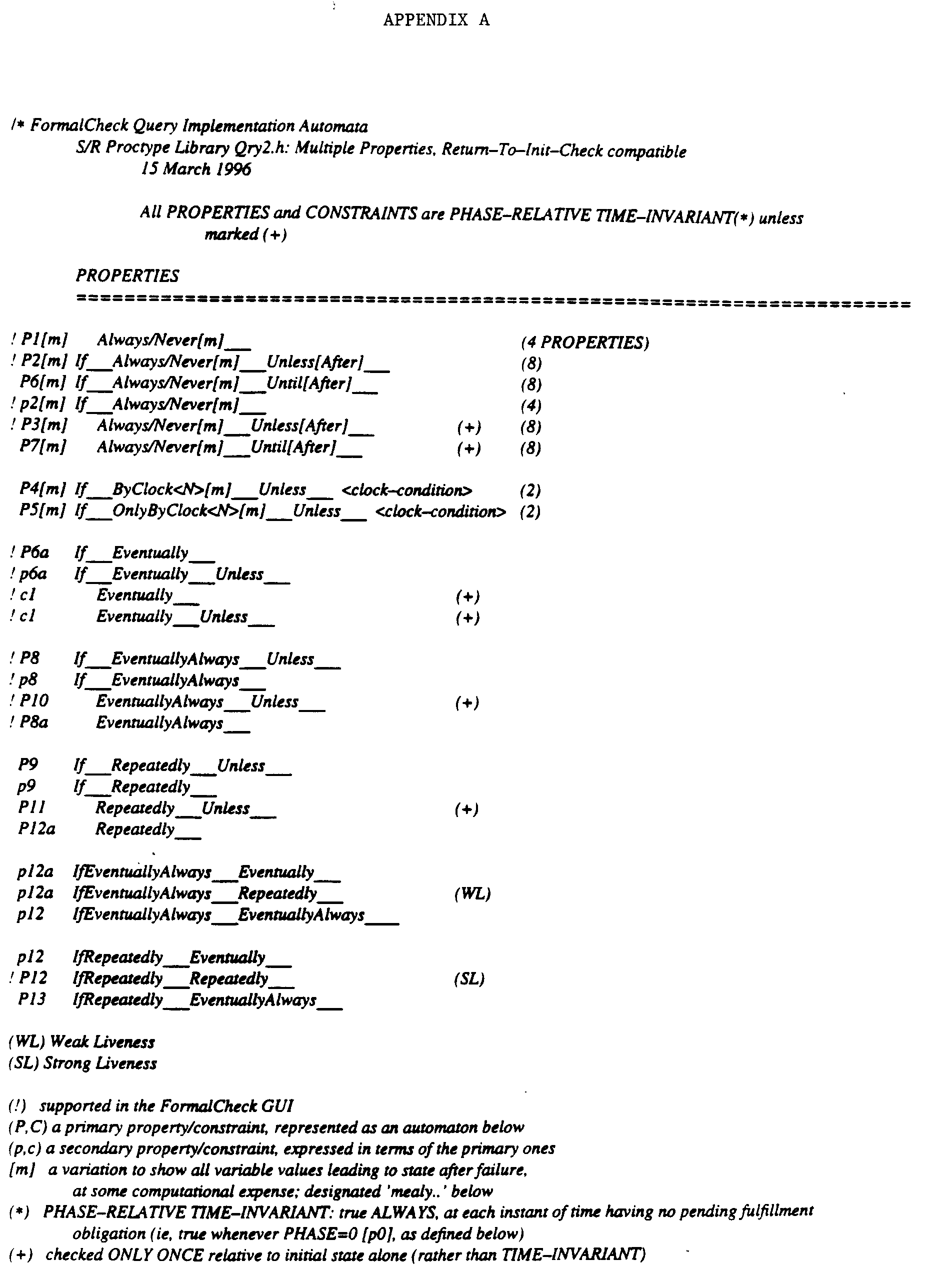

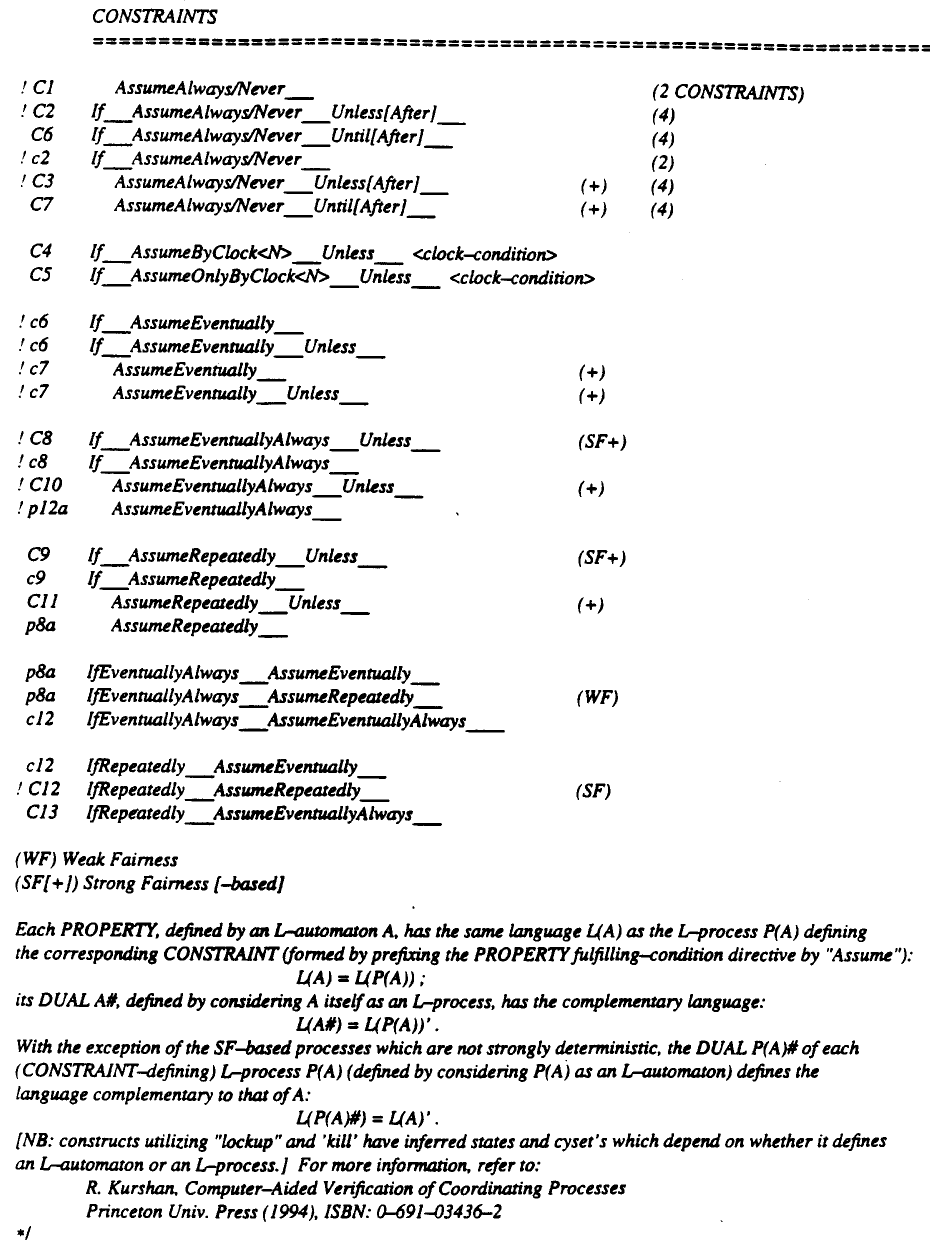

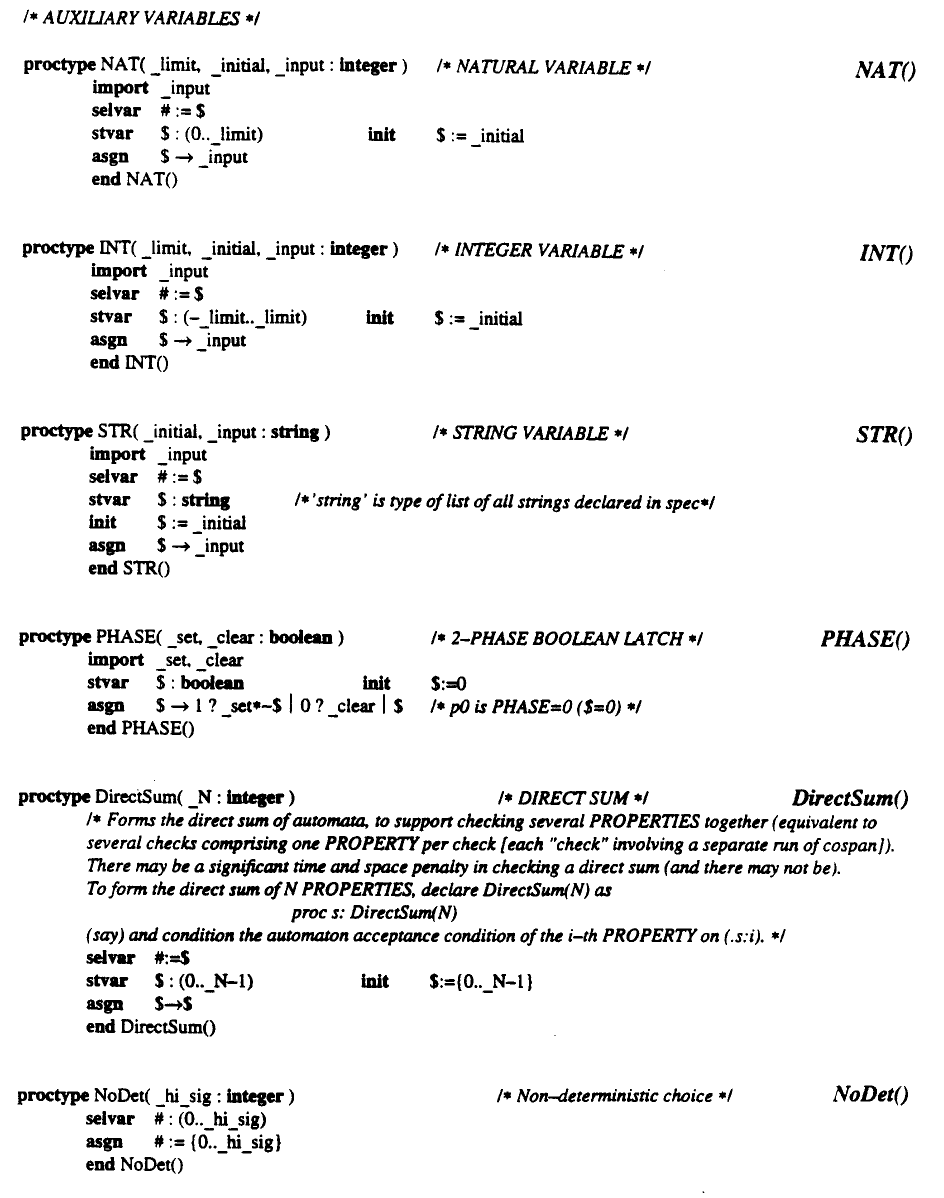

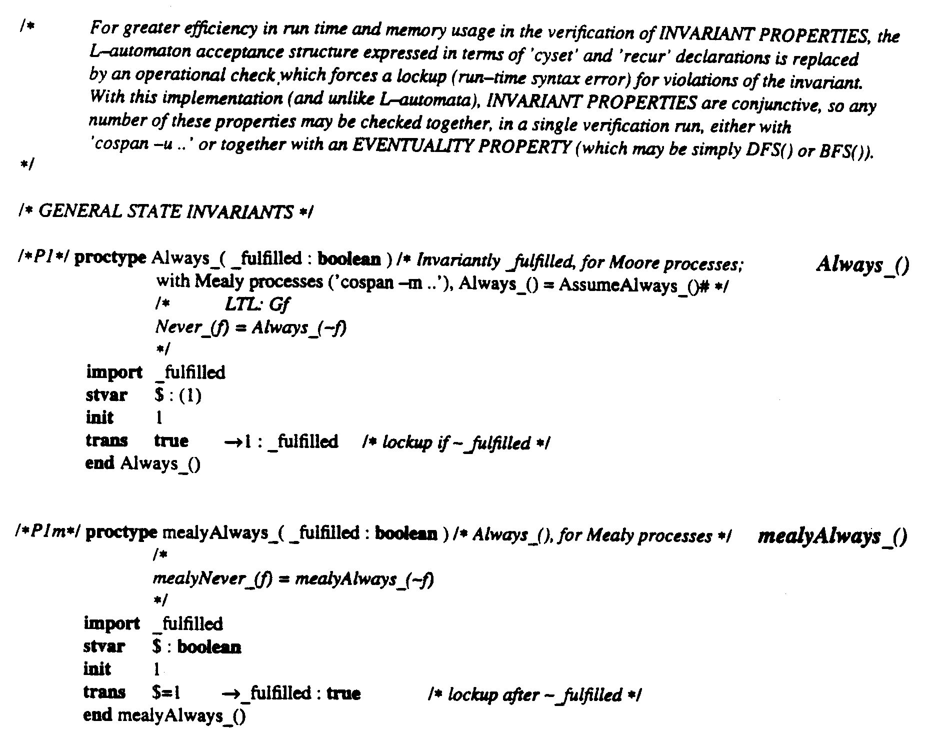

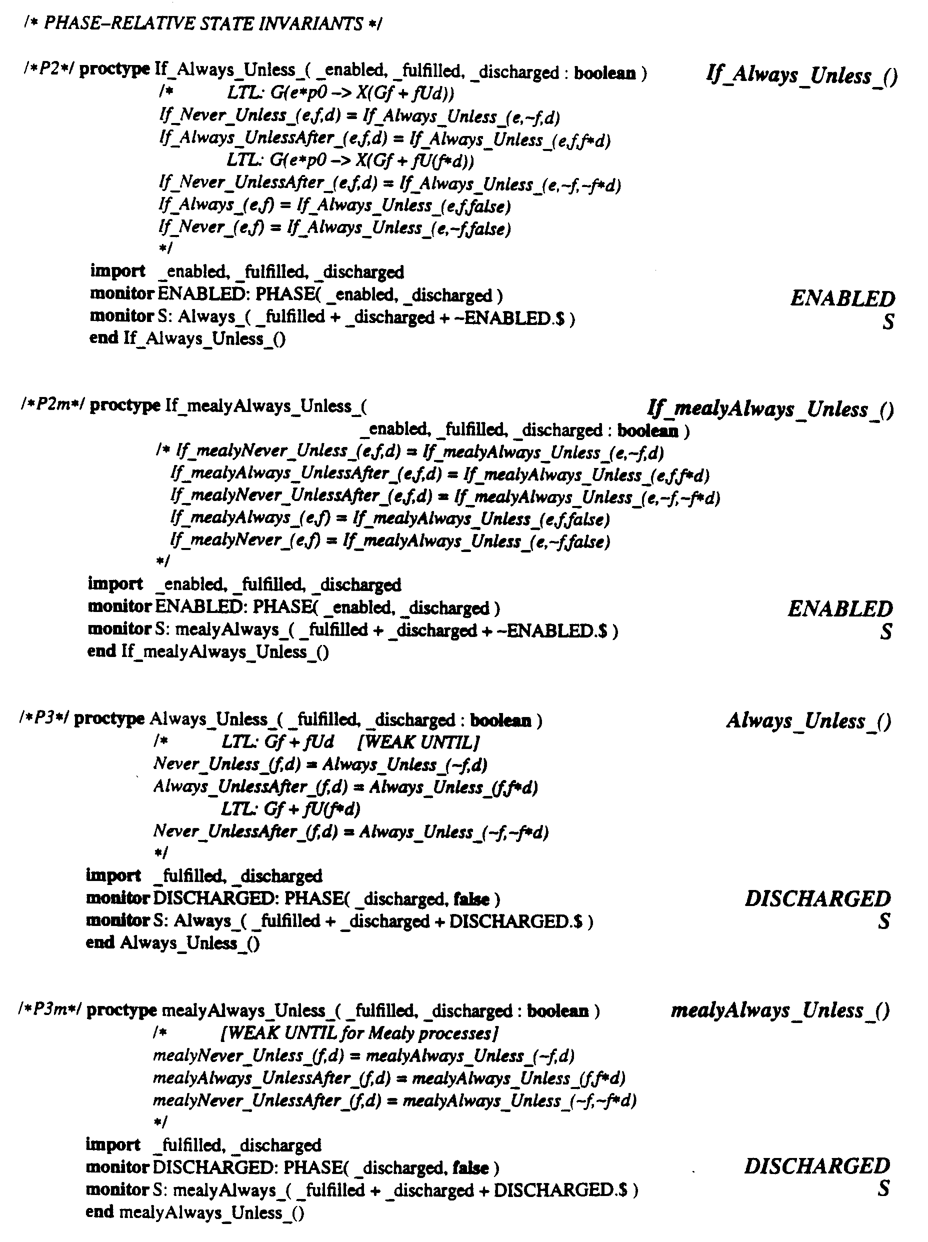

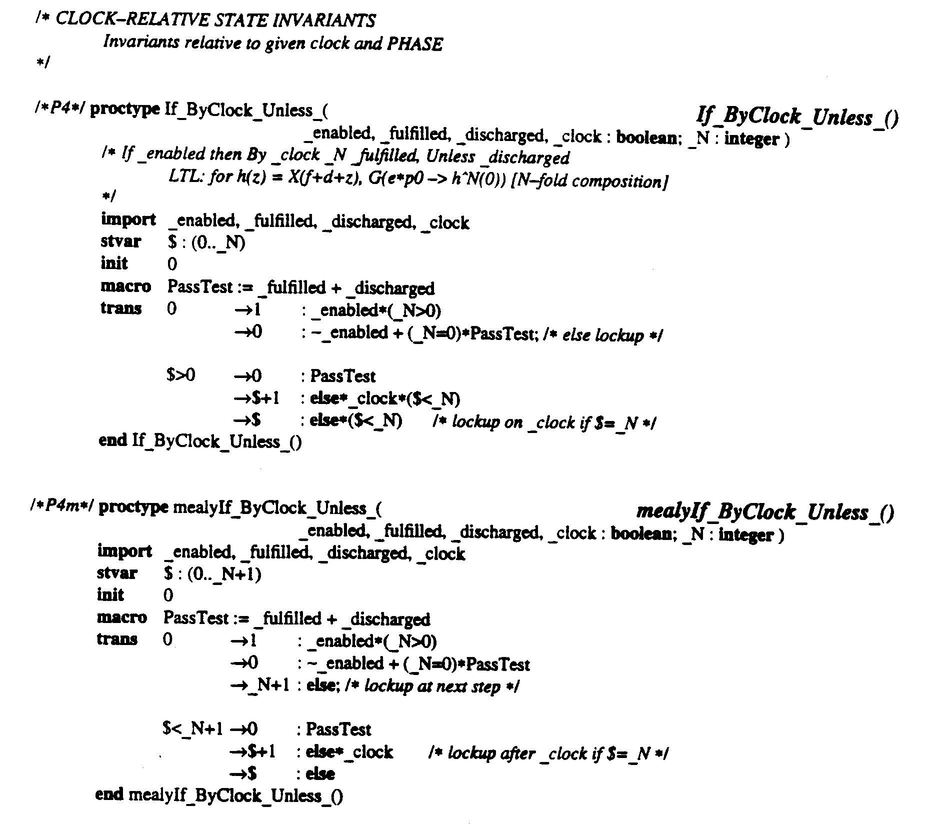

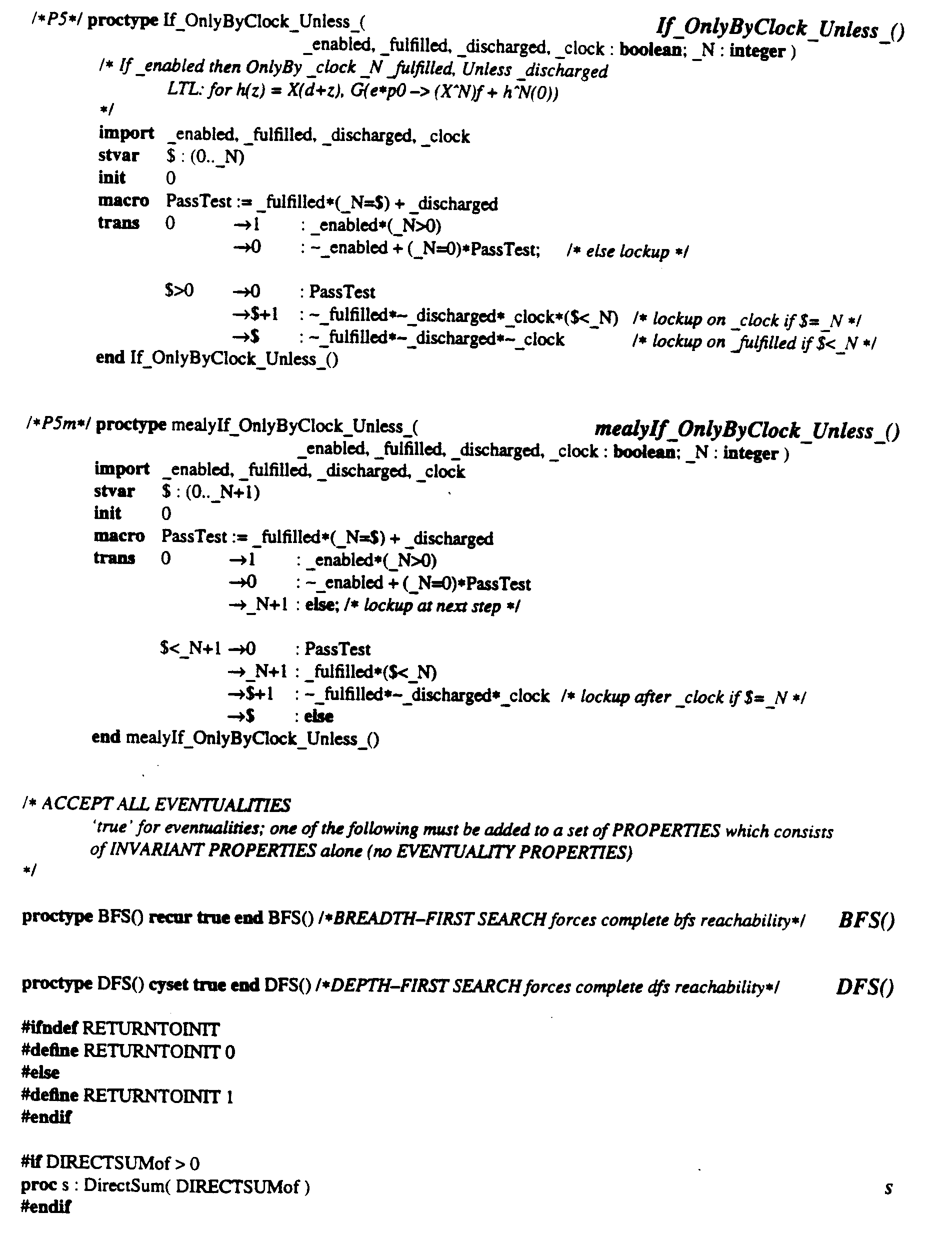

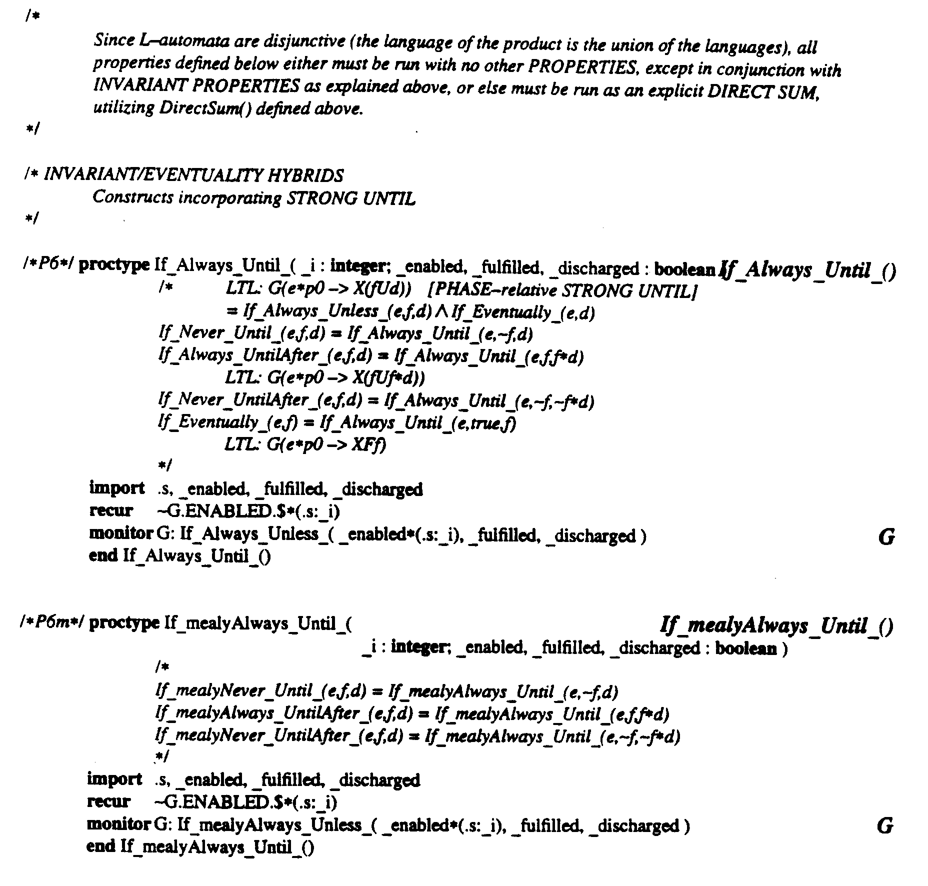

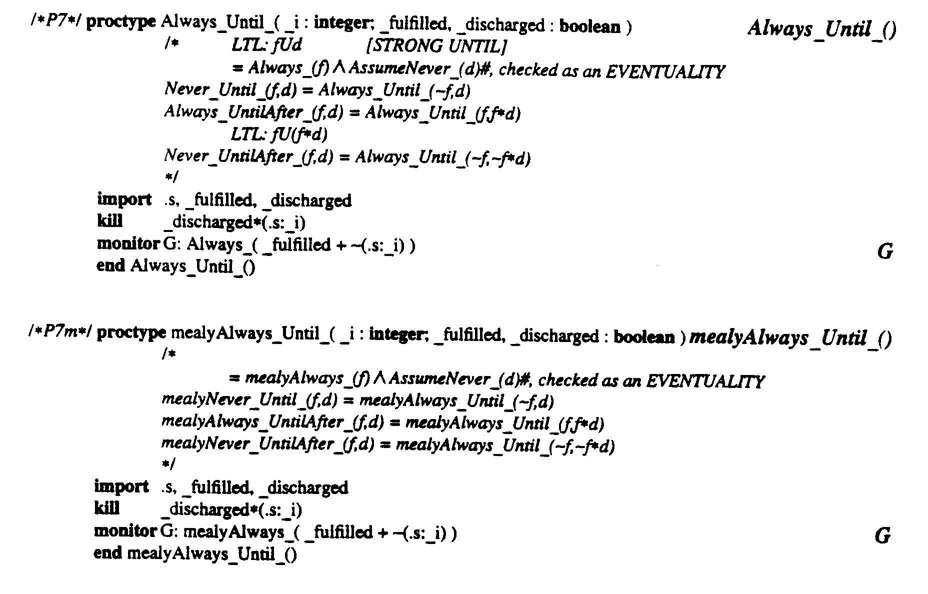

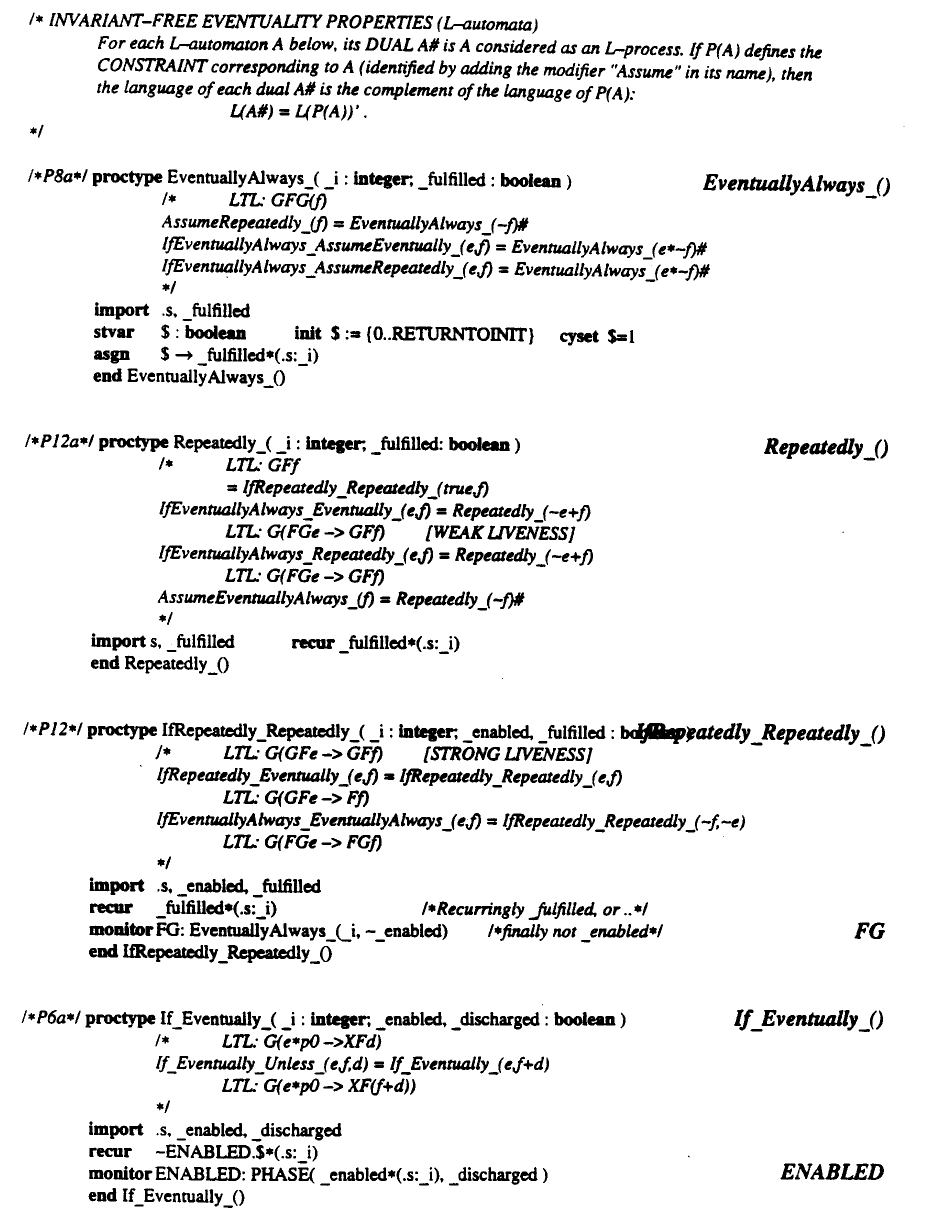

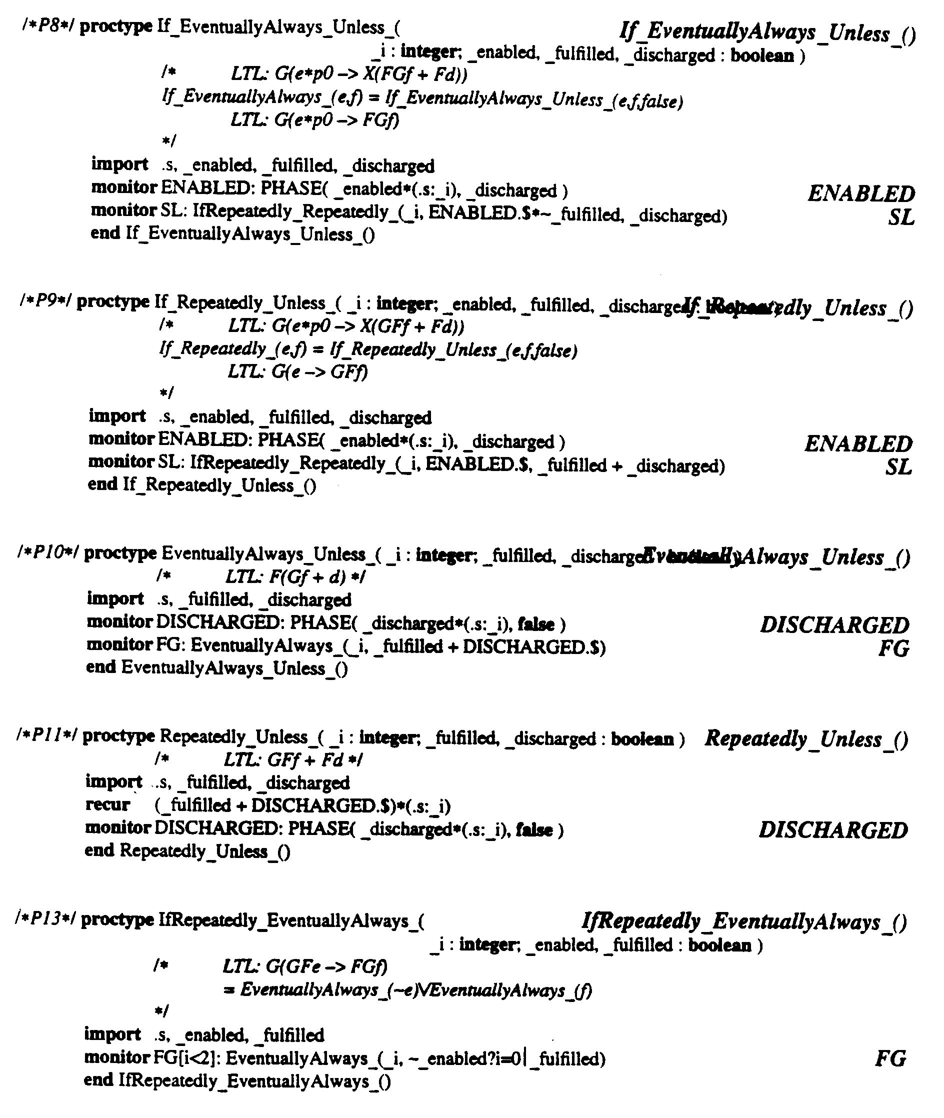

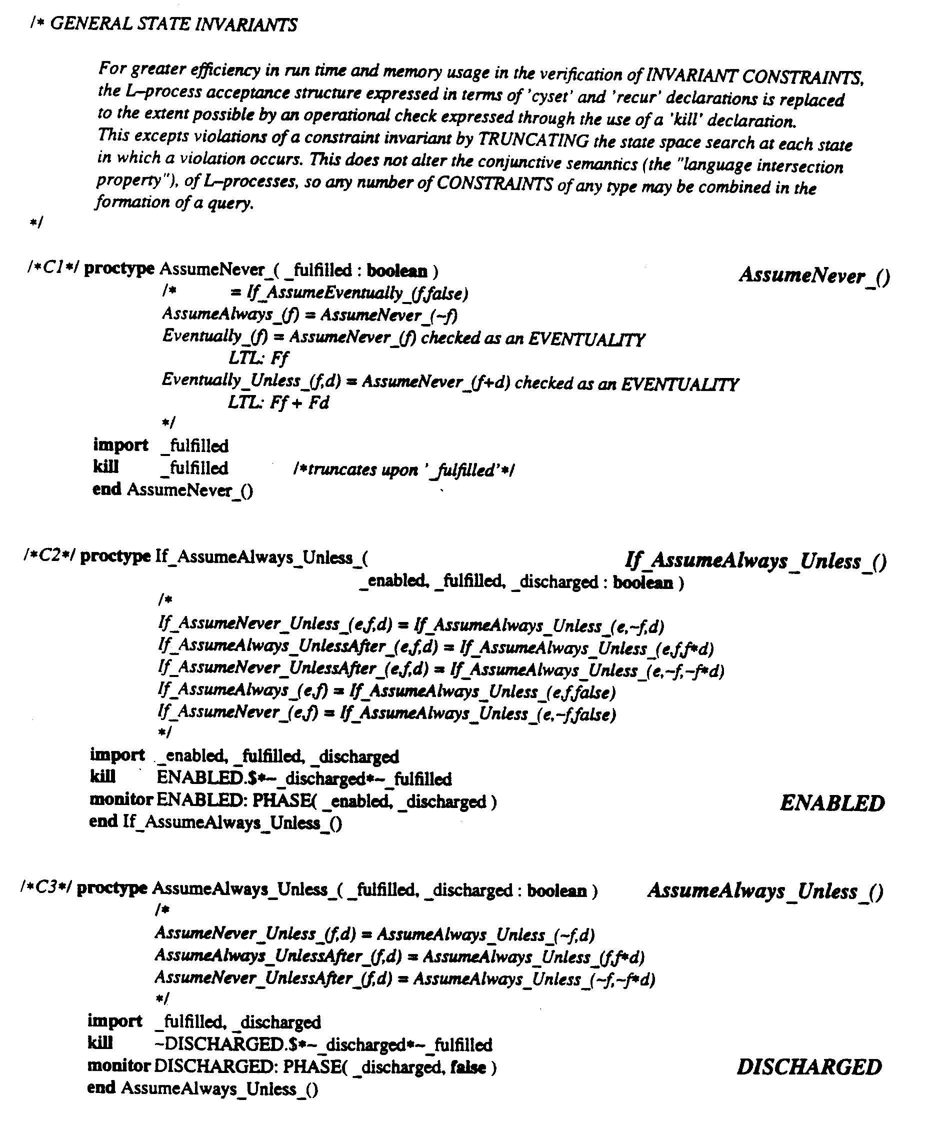

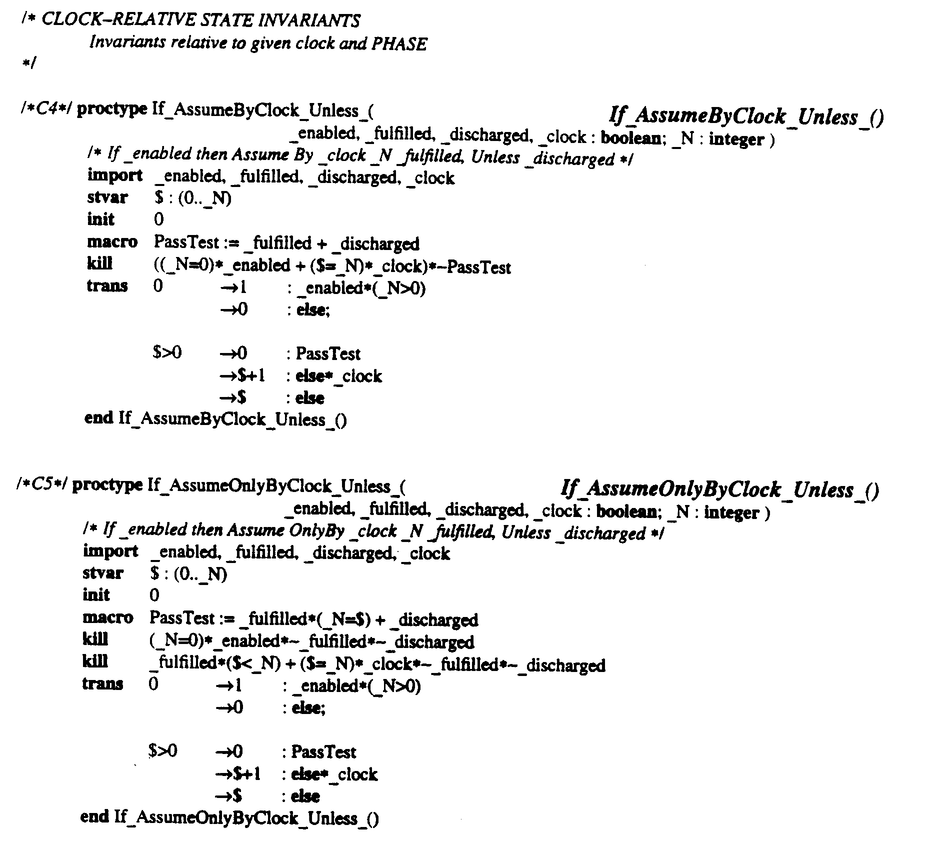

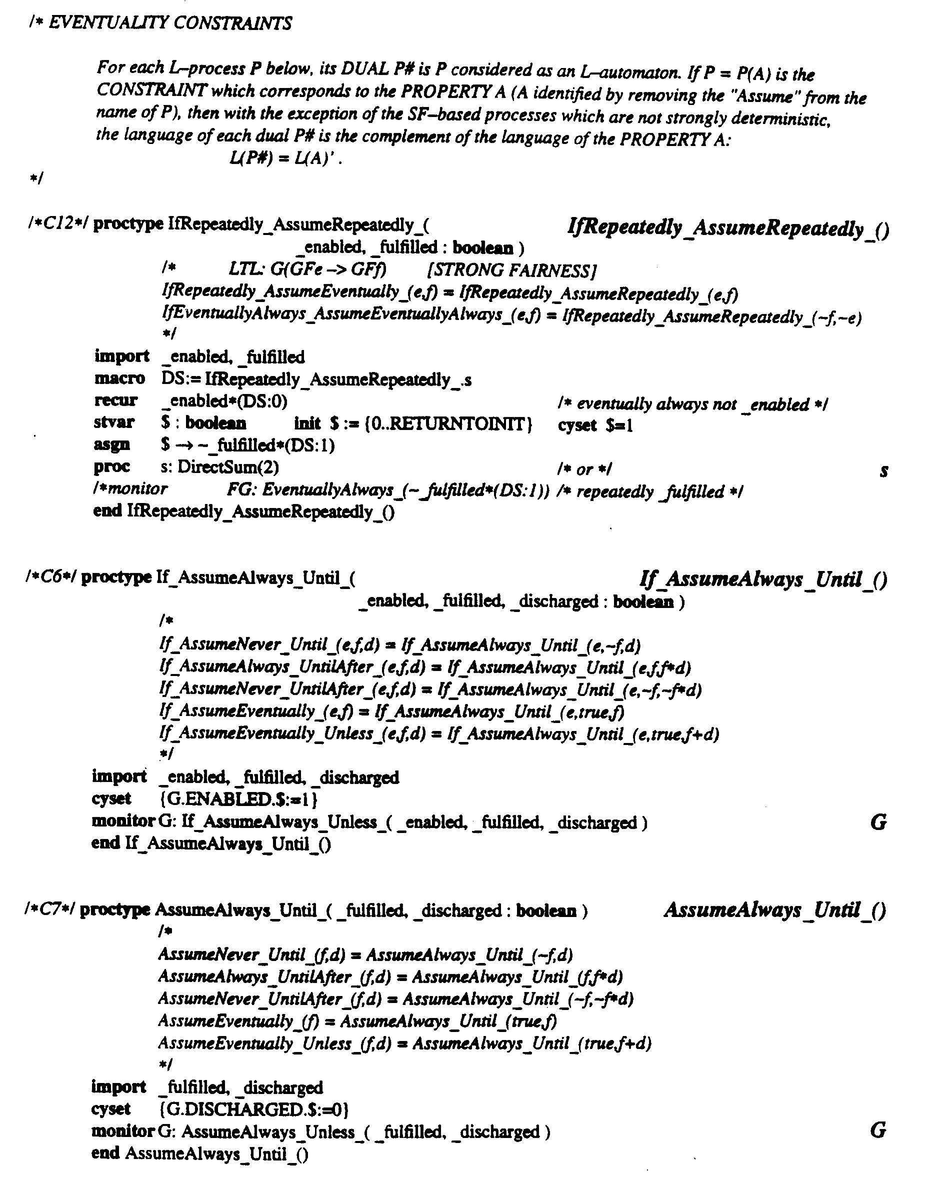

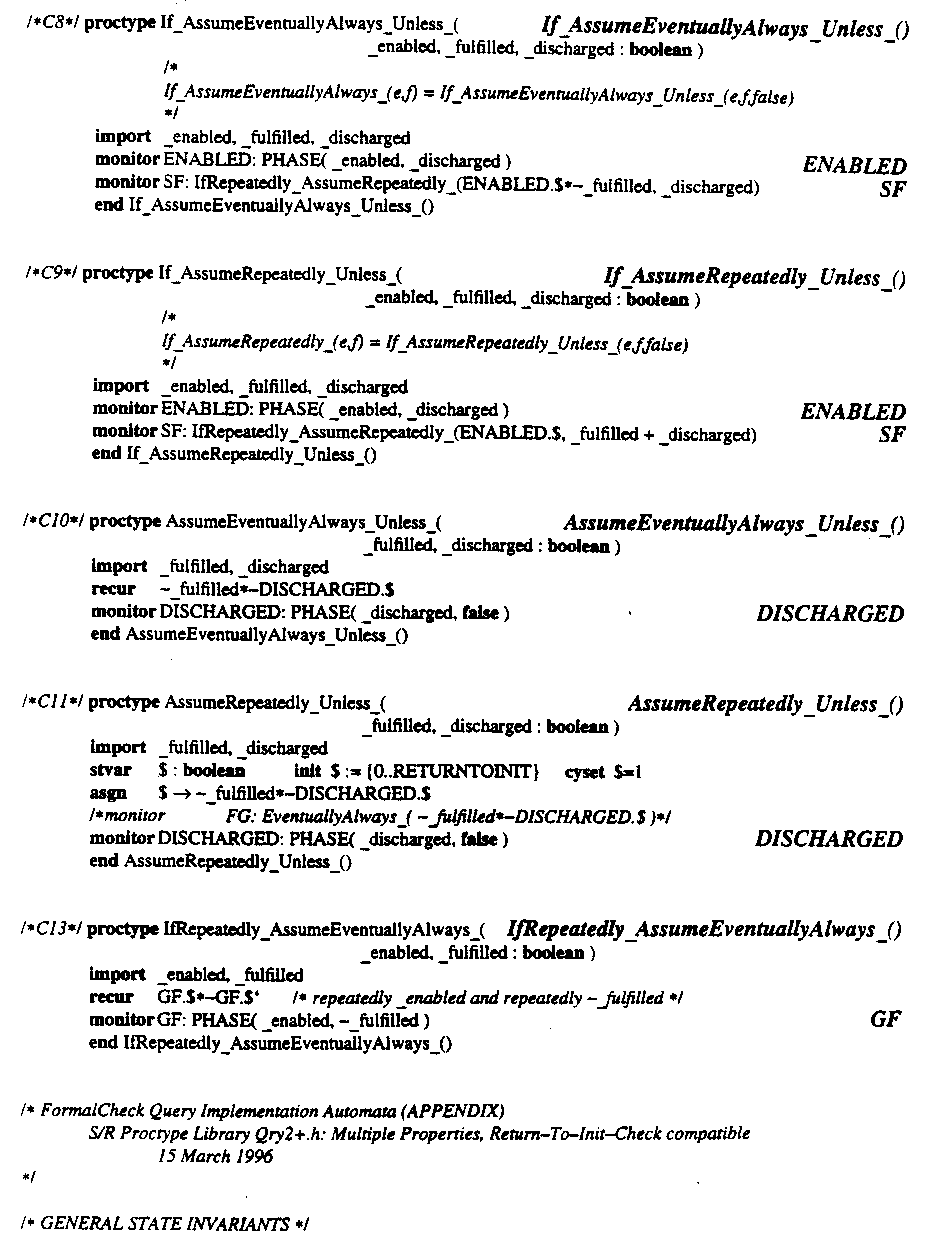

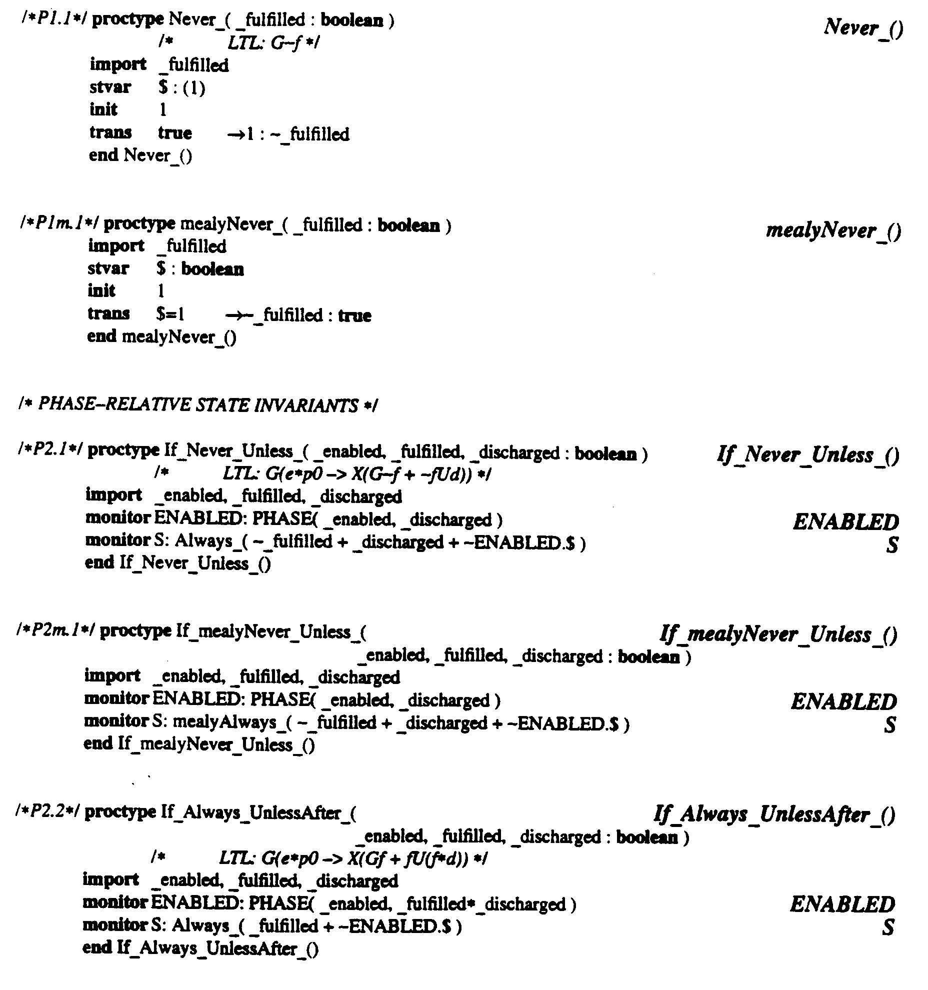

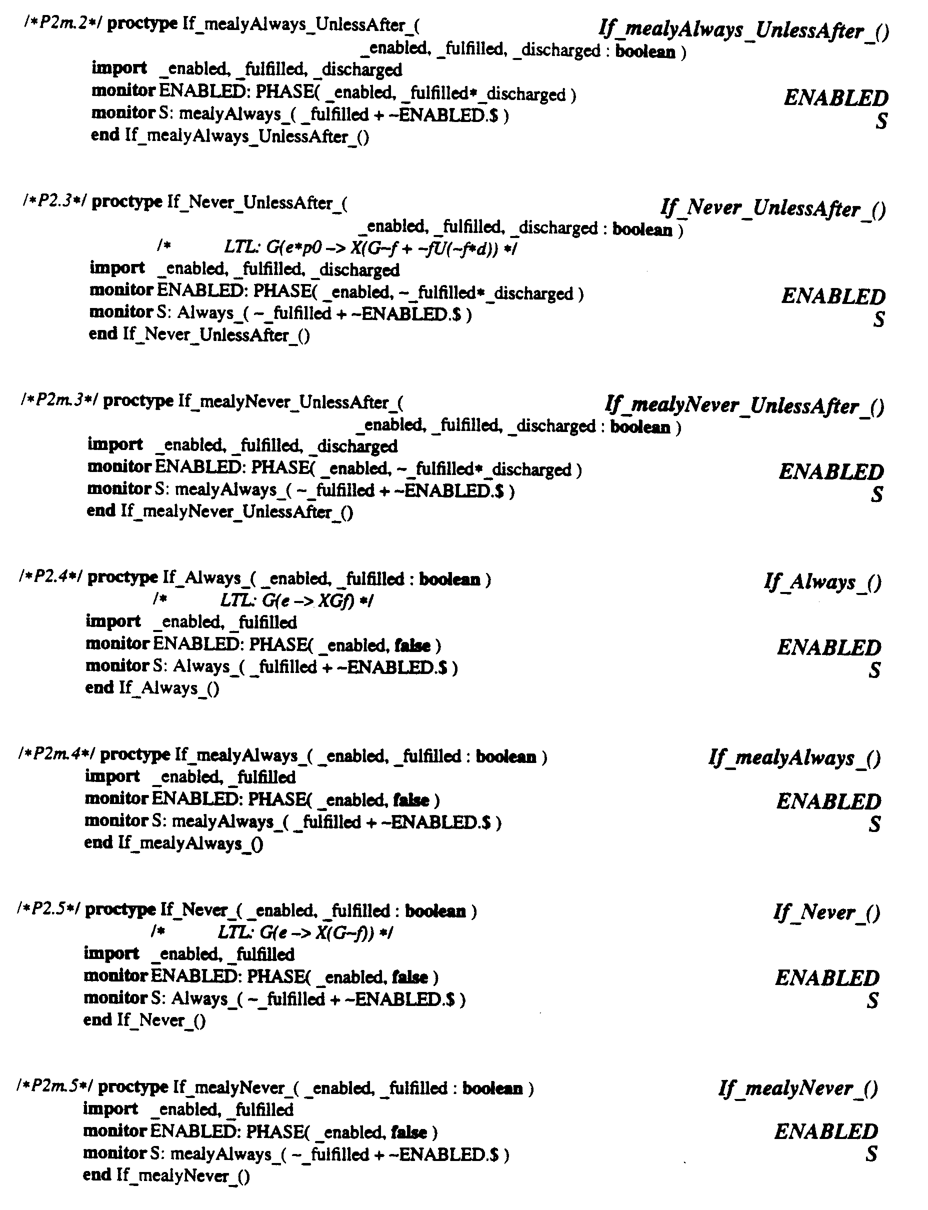

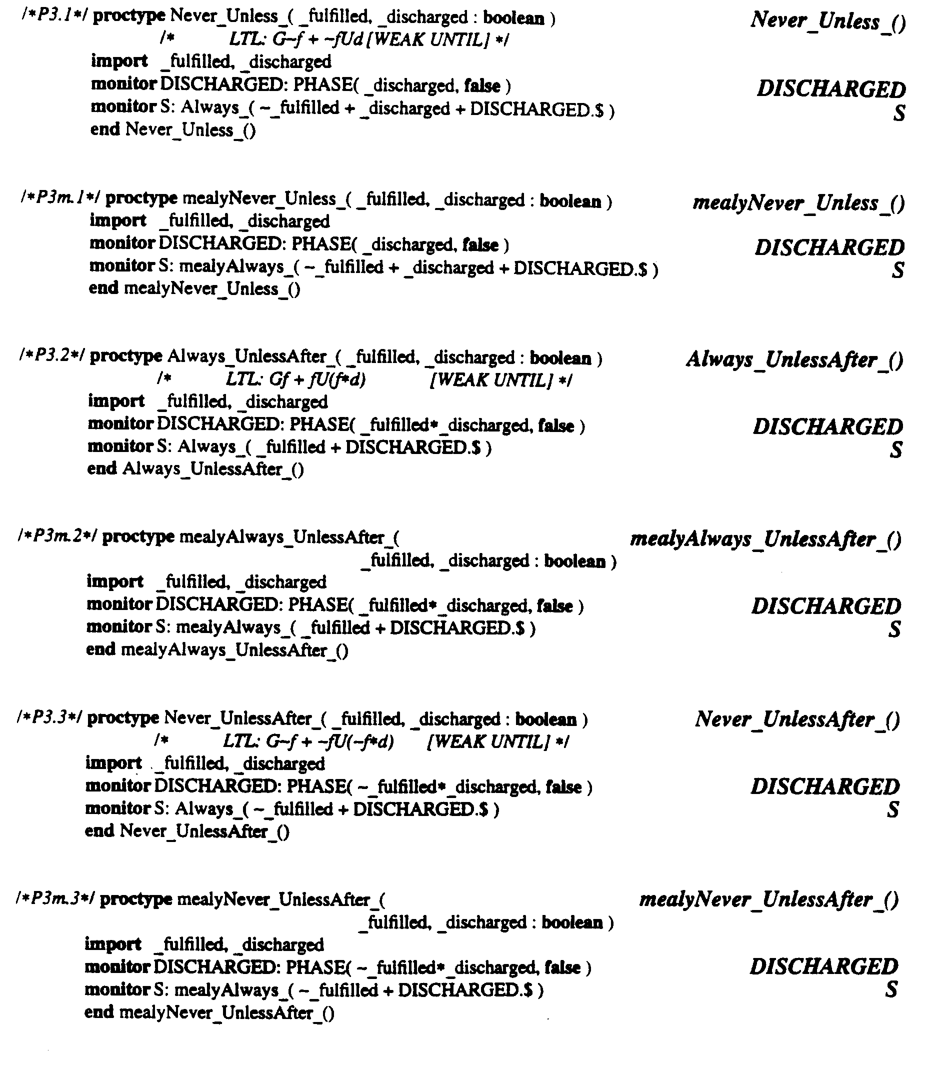

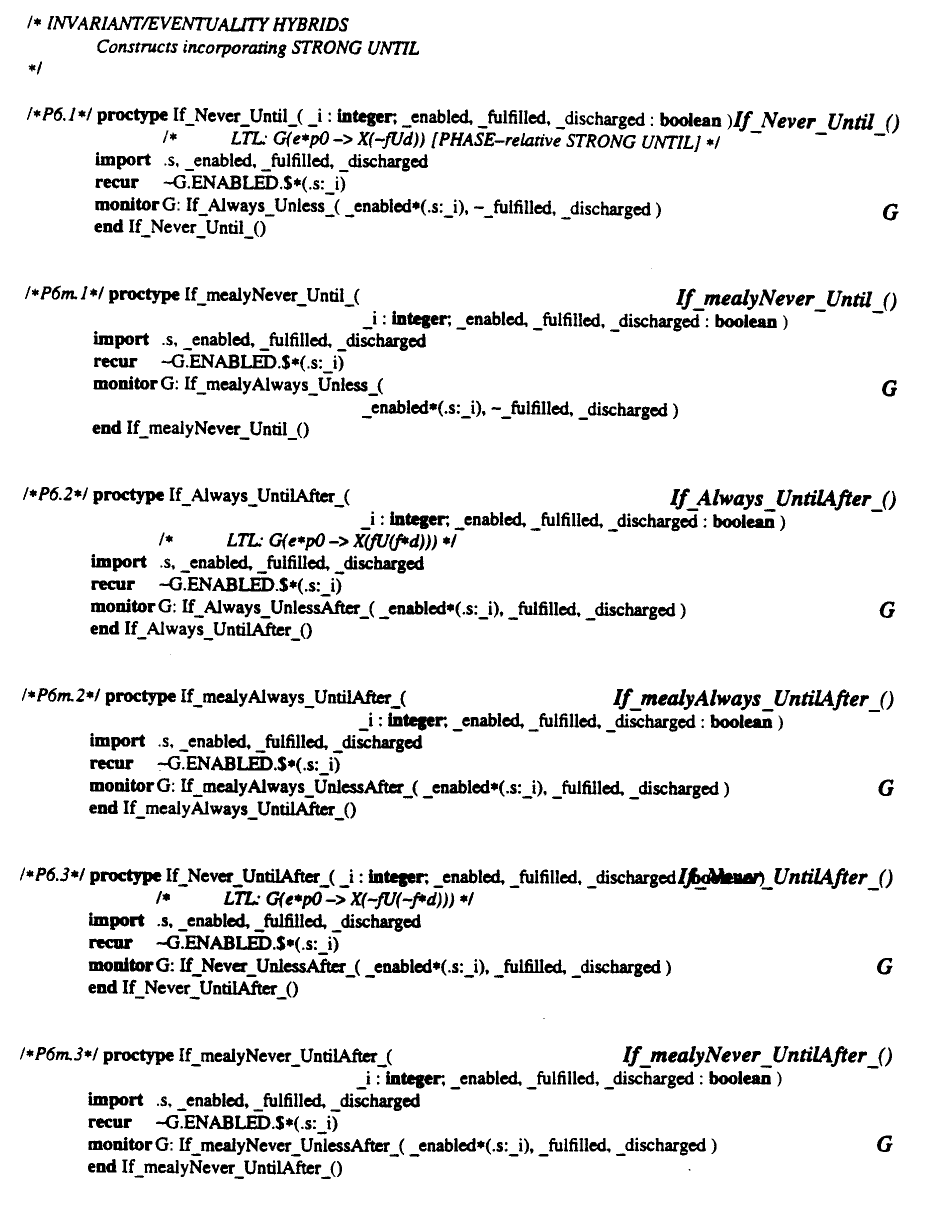

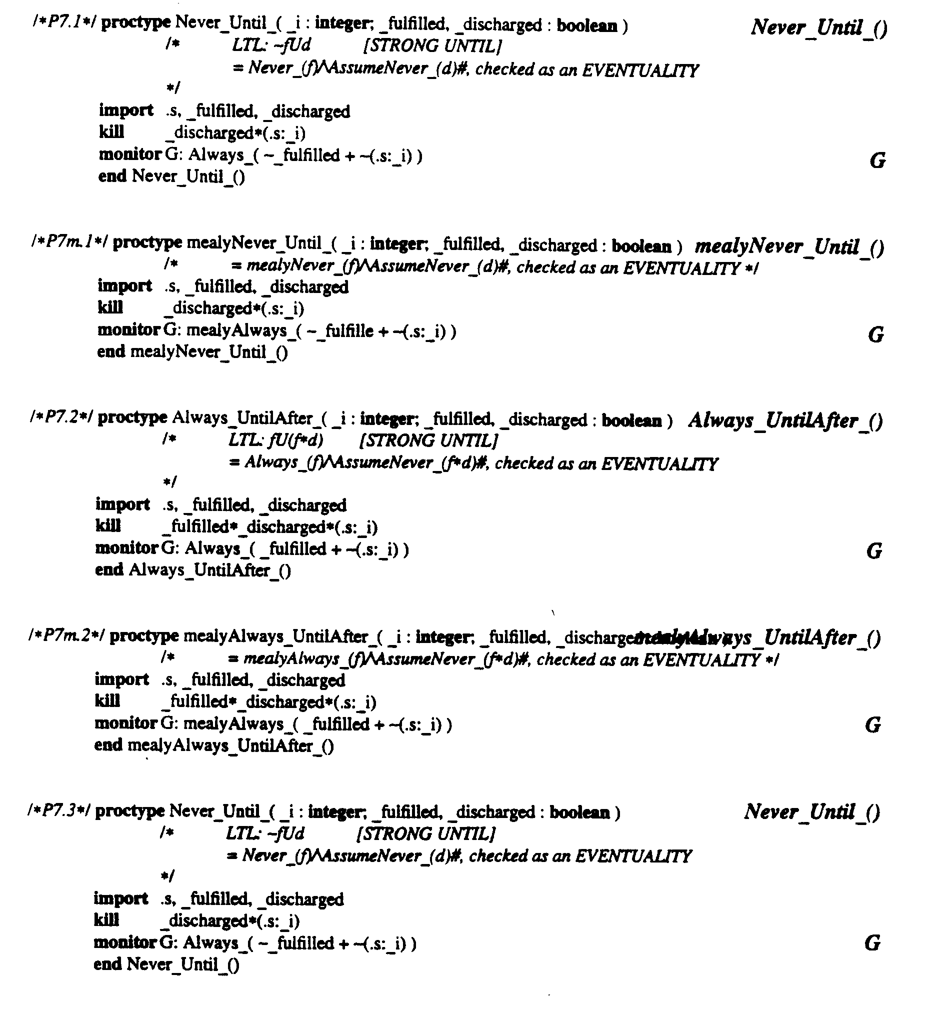

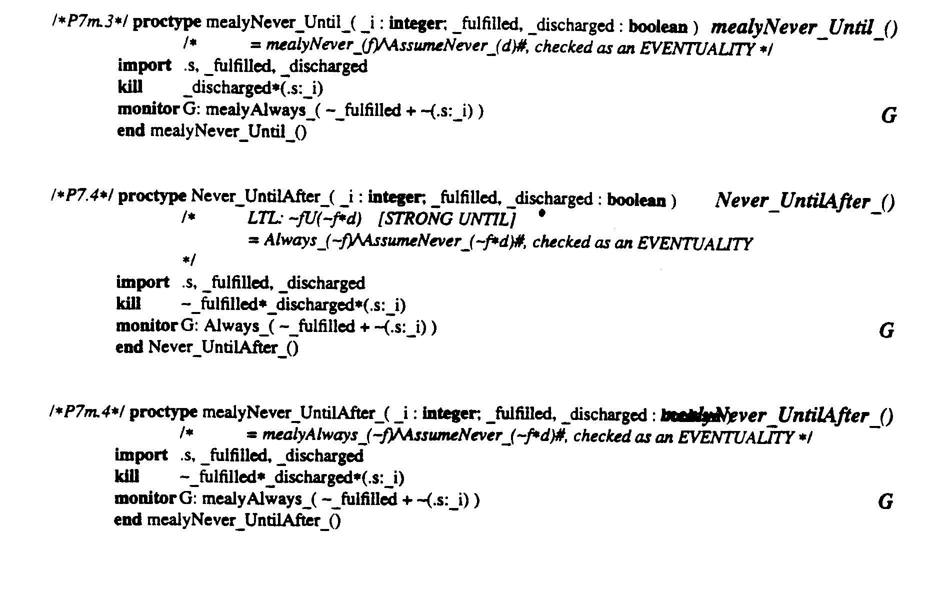

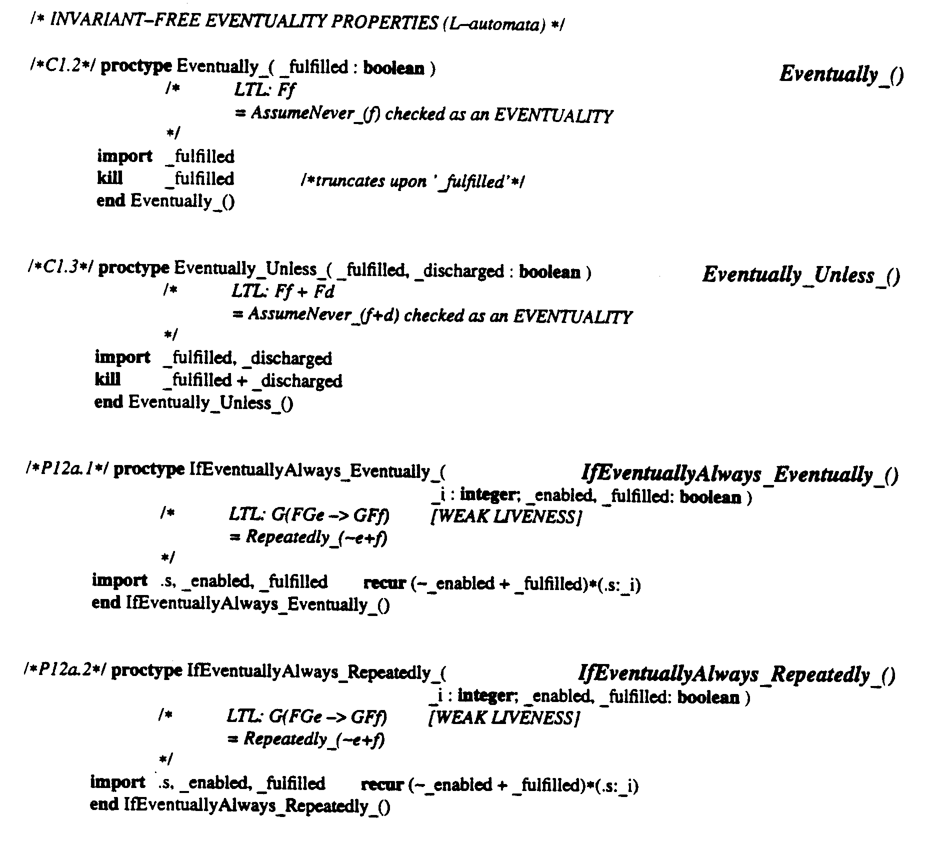

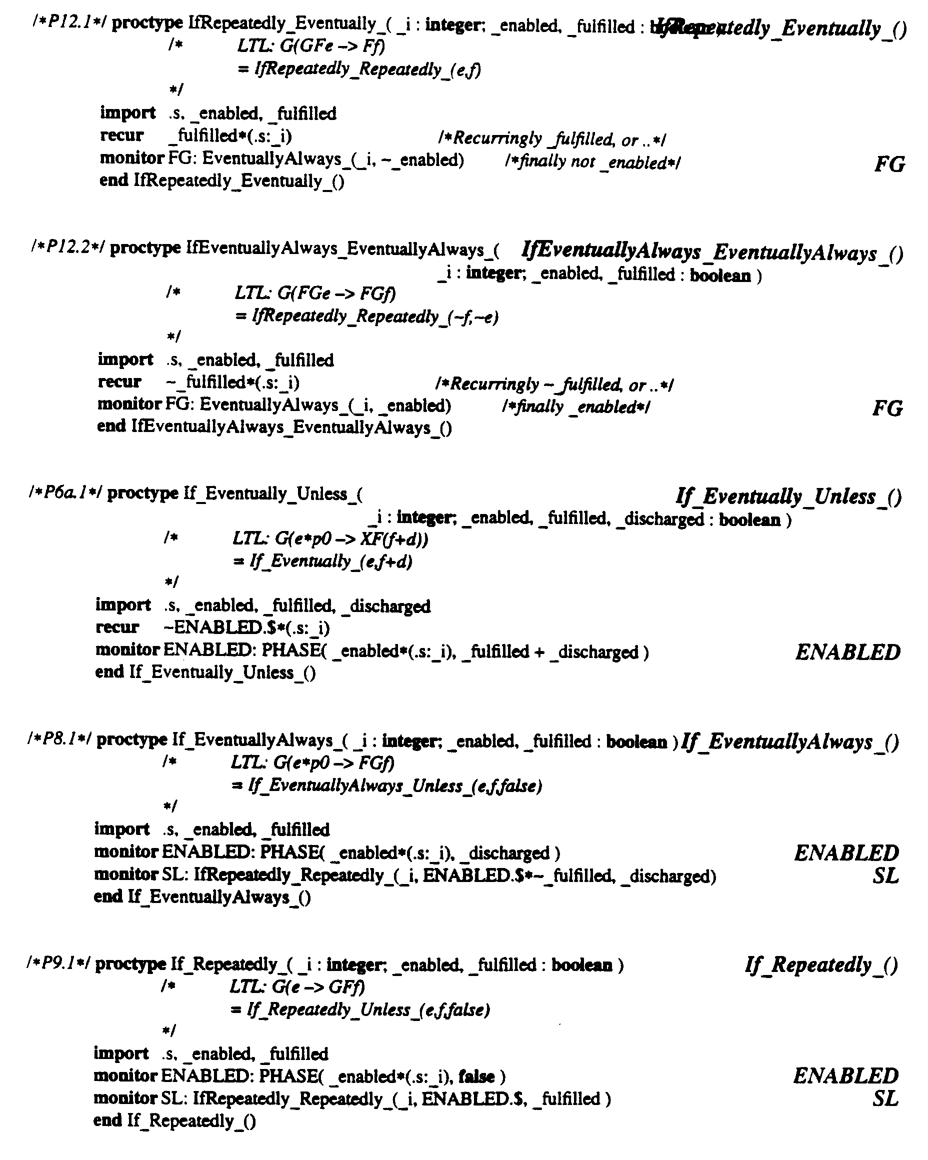

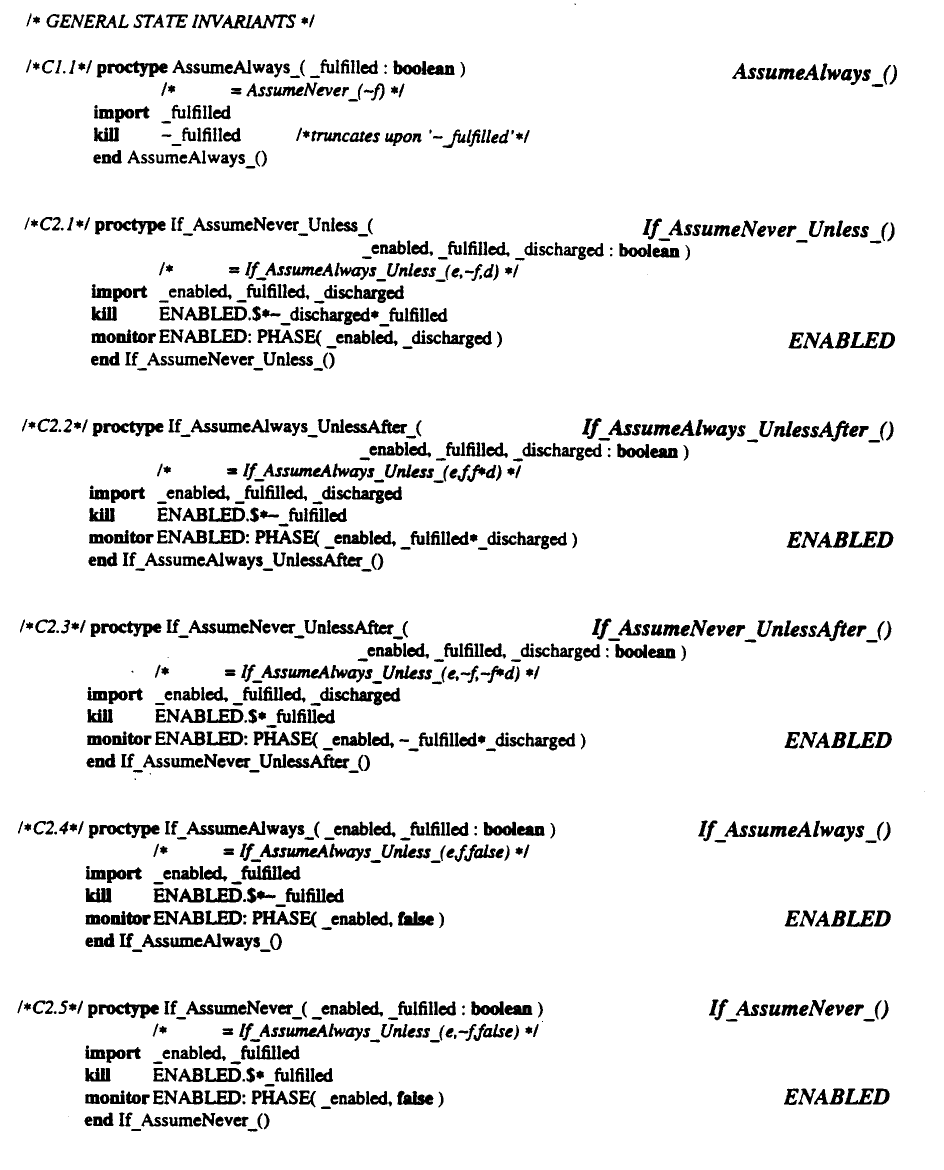

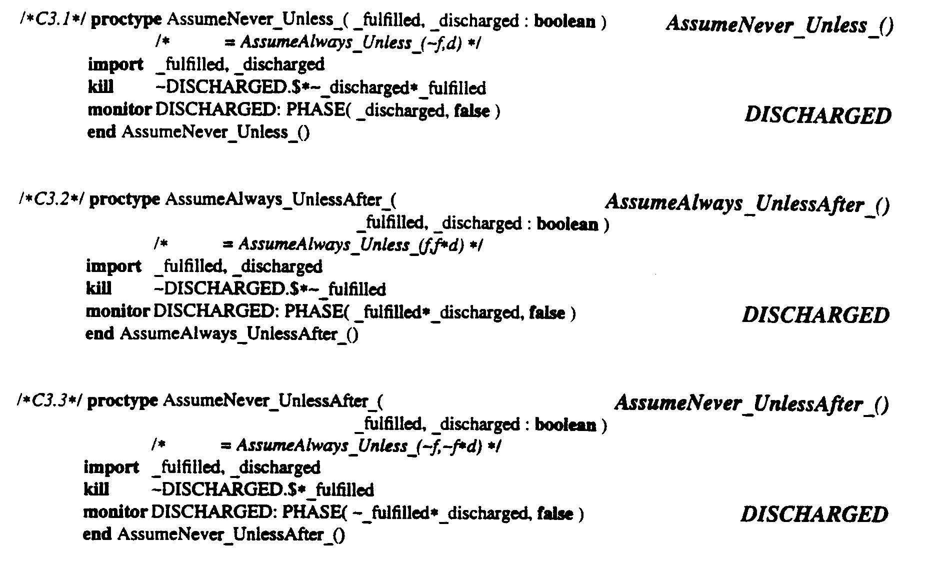

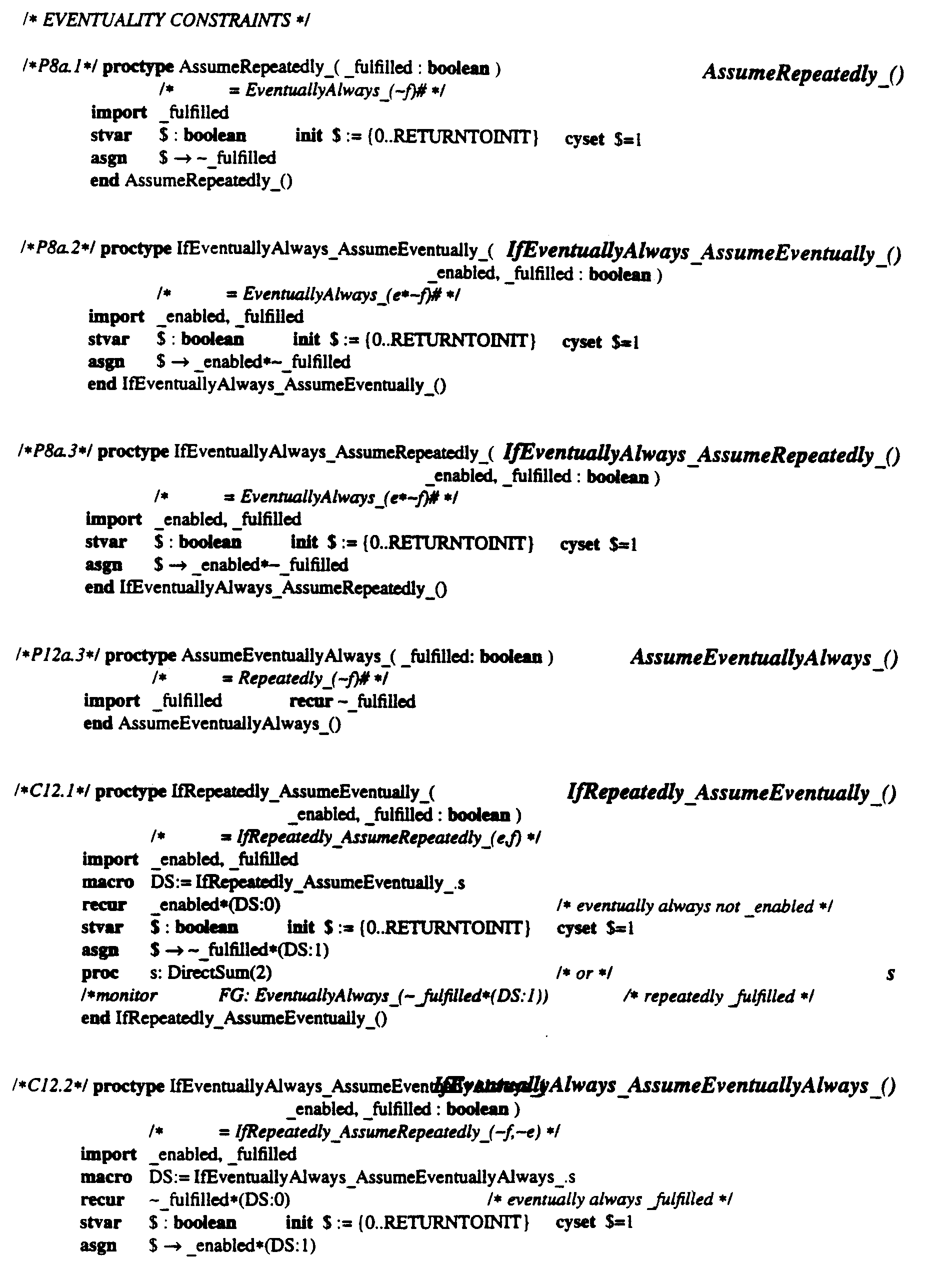

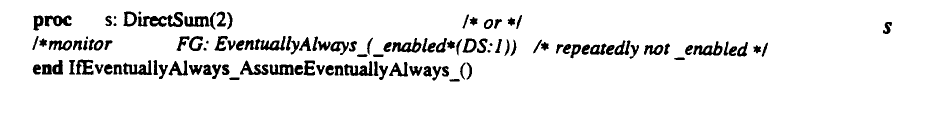

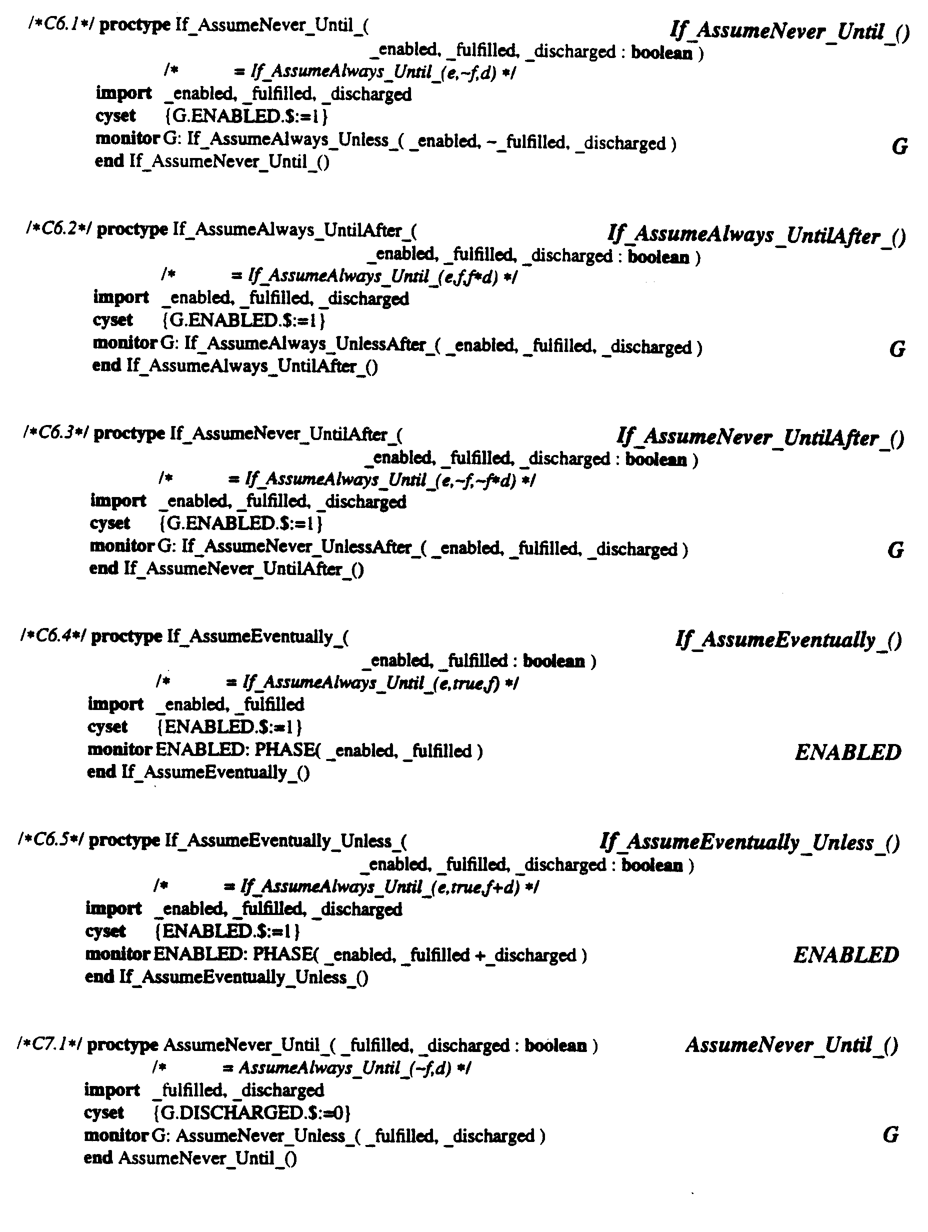

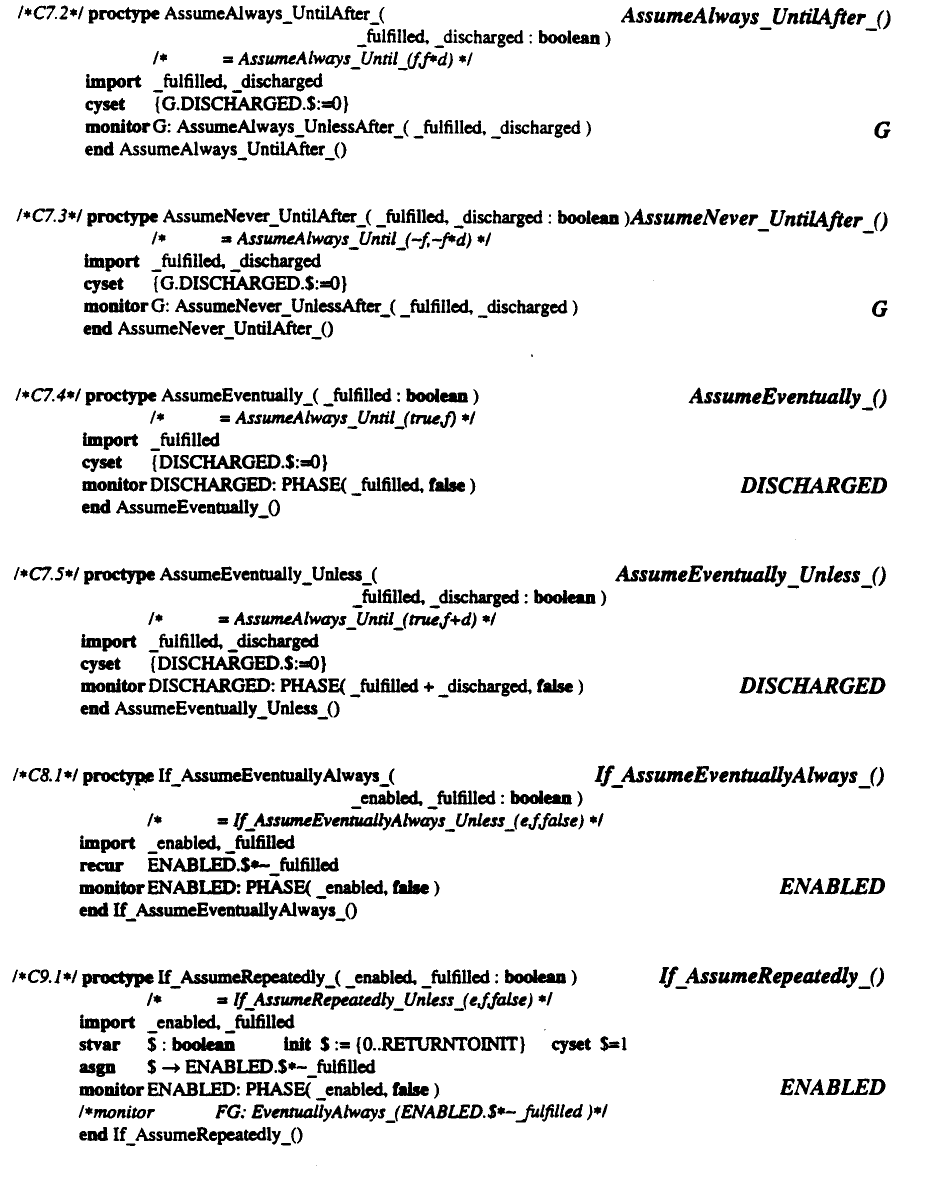

## Claims

1. An apparatus for defining a system design specification, the apparatus comprising:
a library having a finite set of templates, each template having at least one entry space; and
means for filling a set of said entry spaces of a selected template with a set of system expressions to form a filled template that defines an intended behavioral attribute of a system model.

2. The apparatus of claim 1 wherein said set of entry spaces comprise an entry space (X) for a fulfilling condition, an optional entry space (Y) for an enabling condition and an optional entry space (Z) for a discharging condition, said fulfilling condition entry space (X) for accepting a system expression that defines a fulfilling condition which must be true at some time, said optional enabling condition entry space (Y) for accepting a system expression that defines an enabling condition under which said fulfilling condition must be fulfilled, and said optional discharging condition entry space (Z) for accepting system expresson that defines a discharging conditon under which said fulfilling condition no longer need be fulfilled.

3. The apparatus of claim 2 wherein each said entry space has an associated qualifier.

4. The apparatus of claim 3 wherein said fulfilling condition entry space (X) has an associated fulfilling qualifier (B) for qualifying said fulfilling conditon temporally, said enabling condition entry space (Y) has an associated enabling qualifier (A) for qualifying said enabling condition temporally, and said discharging conditon entry space (Z) has an associated discharging qualifier (C) for qualifying said discharging qualifier temporally.

5. An apparatus for defining a system design specification, the apparatus comprising:
means for selecting a template from a library comprising a finite set of templates, said selected template having a set of qualifiers and a set of entry spaces, each qualifier being associated with an entry space; and
means for inputting system expresions into said entry spaces of said selected template, said system expressions and said associated qualifiers, in combination, defining a system behavioral attribute.

6. A system for generating a design specification for a model, the system comprising:
a library comprising a finite set of templates, each template having a set of qualifiers, each qualifier having an associated entry blank;
means for receiving parameters into said associated entry blanks to form a filled template that defines a system behavioral attribute; and
means for generating, from said filled template, a body of computer executable code, said computer executable code being usable by a testing tool to test said system behavioral attribute in a model.

7. An apparatus for defining a design specification of a system, the apparatus comprising a finite set of templates, each template having a format for accepting a set of parameterized inputs such that said template, when filled with said parameterized inputs, defines an expected behavioral attribute of the system model.

8. A method for defining a design specification of a system, the method comprising the steps of:
receiving a set of inputs, each input representing a parameter that describes a system attribute; and
filling a set of templates, selected from a finite template set, with information based on said set of inputs, each template of said finite template set having a format for accepting said parameters that describe said system attributes such that each said filled template defines a system behavioral attribute.

9. A method for optimizing the conversion of a set of logic expressions that define behavioral attributes of a system model to automata, comprising the steps of:
identifying each logic expression included in a list of expressions, each expression on said list having an associated algorithm for converting a logic expression to an automaton; and
using, for each said identified logic expression, said associated algorithm to convert said identified logic expression to an automaton.
